# EUROPEAN PATENT APPLICATION

(11) **EP 2 858 183 A2**
(43) Date of publication of application: **08.04.2015**
(21) Application number: 14187286.1
(22) Date of filing: 01.10.2014
(51) Int. Cl.: H01R 13/52, H01R 13/631, H01R 13/74

(54) **Connector joining structure**

(30) Priority: 03.10.2013 JP 2013207899; 03.10.2013 JP 2013207900; 28.10.2013 JP 2013223259
(71) Applicant: Yazaki Corporation, Tokyo 108-0073 (JP)
(72) Inventor: Ikeya, Kenichi, Shizuoka, 410-1107 (JP)
(74) Representative: Hoffmann Eitle

(57) **Abstract**

A connector joining structure includes an outer housing mounted on a casing, an inner housing having a terminal to be connected to a terminal of a mating connector mounted in the casing, and a first packing interposed between the outer housing and the inner housing. The first packing is configured to ensure sealing property between the outer housing and the inner housing even upon a position of the inner housing with respect to the outer housing being displaced in at least one of three directions in a three-dimensional space by a predetermined amount with respect to a target value.

## Description

### BACKGROUND

### 1. TECHNICAL FIELD

This disclosure relates to a connector joining structure.

### 2. RELATED ART

JP 2013-131474 A discloses a connector (harness-side connector) 301 shown in FIGS. 1 and 2.

The harness-side connector 301 is split into a terminal joining portion 303 with which a fixing portion 302 used for fixing to a wall portion of an equipment casing 309 is integrally formed, and an equipment waterproof portion 305.

In fitting the connector 301, the terminal joining portion 303 is inserted into a through hole 311 formed in a wall portion of the equipment casing 309, the terminal joining portion 303 is positioned by making the terminal joining portion 303 aligned with an opening position of an equipment-side connector (mating connector) 307, and the equipment waterproof portion 305 is independently positioned with respect to the through hole 311. The equipment waterproof portion 305 is mounted on an outer periphery of the terminal joining portion 303 in a close contact manner, and is brought into close contact with the through hole 311 thus partitioning one side and the other side of a wall portion from each other. Due to such a constitution, the harness-side connector 301 can acquire both reliability in connection of the terminal and waterproof performance of the terminal.

The connector 301 includes: a sealing member 320 which is brought into close contact with the equipment waterproof portion 305 and the through hole 311 thus partitioning one side and the other side of the wall portion of the equipment casing 309; and a sealing member 322 which is brought into close contact with opposedly-facing surfaces of the fixing portion 302 and the equipment waterproof portion 305 in the insertion direction of the terminal joining portion 303 with respect to the equipment waterproof portion 305 thus partitioning the fixing portion 302 and the equipment waterproof portion 305.

JP 2010-244976 A discloses a connector joining structure 401 shown in FIG. 3. The connector joining structure 401 is configured such that a seal packing (face seal packing) 405 is incorporated into a connector body portion 403 of a connector 402 for holding an electrical contact with a mating connector mounted on an equipment side.

The seal packing 405 is pressed by being sandwiched between an equipment casing and the connector body portion 403 thus providing a waterproof between the connector 402 and the equipment casing.

JP 2003-31323 A discloses a connector joining structure 451 shown in FIGS. 6 and 7.

The connector joining structure 451 includes: a harness side connector 453; a board side connector 455; and an equipment casing 457.

A fixing portion 459 for mounting the harness side connector 453 on the equipment casing 457 is integrally mounted on the harness side connector 453. A terminal 461 for board connection is mounted on the board side connector 455. The terminal 461 for board connection is formed using a material having high rigidity such as metal, and is fixed to a board 463 by soldering or the like.

The board side connector 455 is preliminarily fixed to the equipment casing 457 in the inside of the equipment casing 457, and the harness side connector 453 is fitted into (joined to) the board side connector 455 by insertion. In fitting the harness side connector 453 into the board side connector 455, the harness side connector 453 passes through a through hole 465 formed in the equipment casing 457, and is fitted into the board side connector 455.

When the fitting engagement between the harness side connector 453 and the board side connector 455 is finished, the harness side connector 453 is fixed to the equipment casing 457 by a bolt 470 engaged with the fixing portion 459.

### SUMMARY

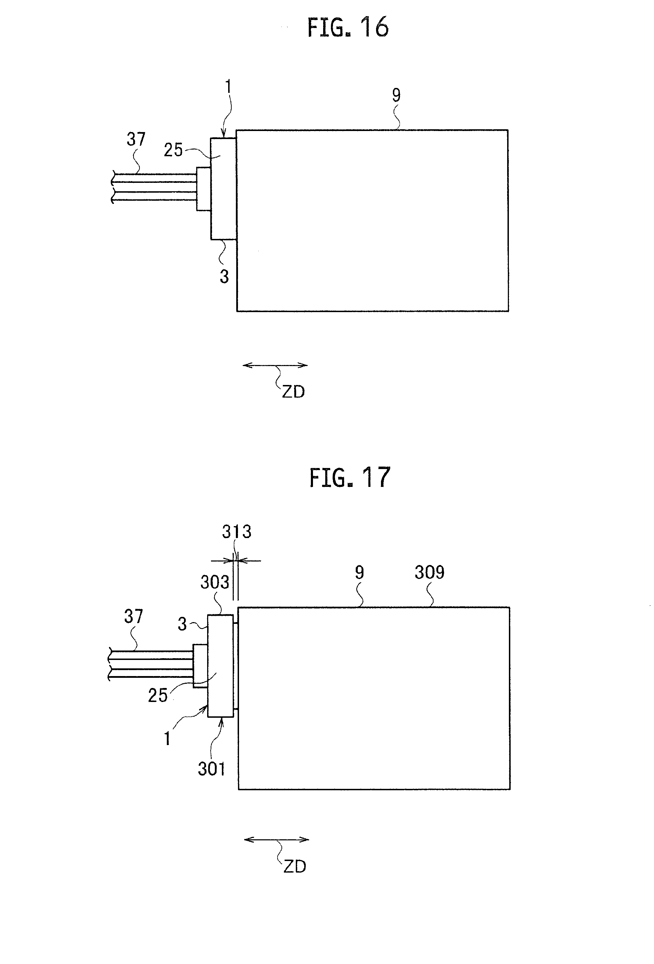

In the connector 301, the fixing portion 302 is integrally formed with the terminal joining portion 303. Accordingly, when a mounting position of the equipment side connector 307 in the Z direction is displaced to a side opposite to the insertion direction of the connector 301 (equipment casing 309 side), as shown in FIG. 17, a gap 313 is formed between the fixing portion 302 and the equipment casing 309.

It is impossible to distinguish whether the gap 313 is formed due to insufficient fastening of a bolt 330 (a bolt for mounting the harness side connector 301 on the equipment casing 309 using the fixing portion 302) or whether the gap 313 is formed due to the positional displacement of the harness side connector 301.

Accordingly, fitting engagement between the harness side connector 301 and the equipment side connector 307 is not guaranteed.

Further, in the connector 301, partitioning of one side and the other side of the equipment casing 309 and the partitioning between the fixing portion 302 and the equipment waterproof portion 305 are performed using different sealing members 320, 322 respectively and hence, the number of parts is increased thus pushing up the cost.

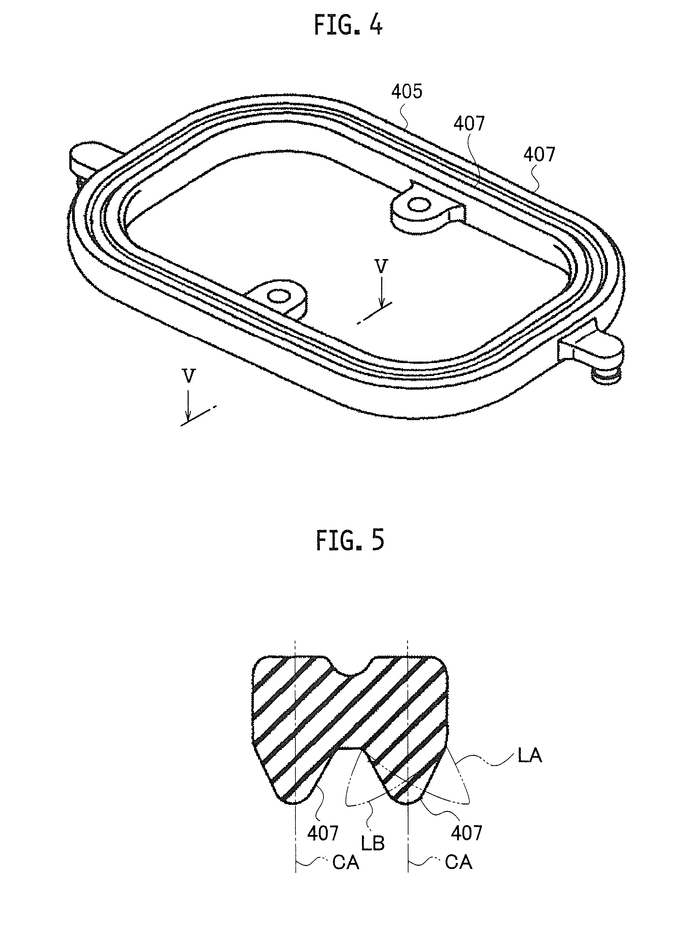

Still further, in the connector joining structure 401, a lip portion 407 of a seal packing (packing) 405 is formed into a symmetrical shape with respect to a center line CA as shown in FIGS. 4 and 5. Accordingly, when the connector 402 is mounted on the equipment casing, the manner of collapsing of the lip portion 407 becomes unstable.

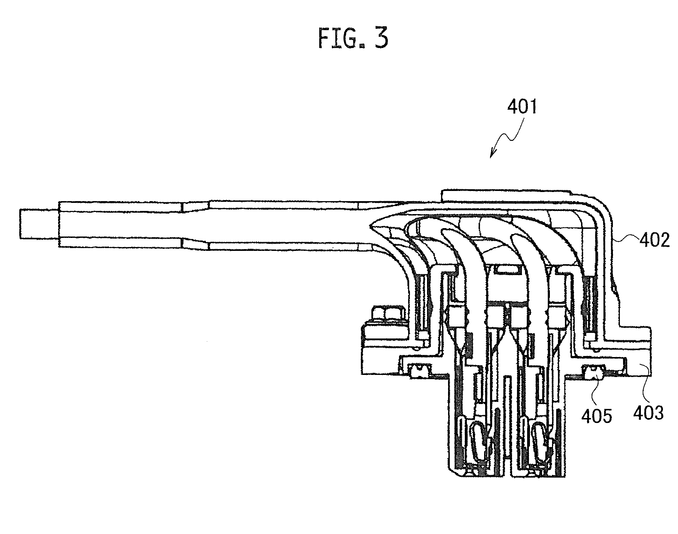

That is, in mounting the connector 402 on the equipment casing, when the alignment for centering the connector 402 (the alignment in the lateral direction shown in FIG. 3 and in the direction orthogonal to a surface of a sheet on which FIG. 3 is drawn) is performed with the seal packing 405 held in a pressed state, the lip portion 407 is pulled by the equipment casing so that it is not possible to understand a side to which the lip portion 407 collapses with respect to the center line CA (for example, see double-dashed chain lines LA, LB in FIG. 3). As a result, there is a possibility that a waterproof performance becomes irregular and is lowered.

Further, in the connecter joining structure 451, in fitting the harness side connector 453 into the board side connector 455, it is necessary to position the harness side connector 453 with respect to the board side connector 455. That is, it is necessary to align the harness side connector 453 with the opening position of the board side connector 455.

However, it is expected that the board side connector 455 and the board 463 are preliminarily fixed to the equipment casing 457 and the harness side connector 453 is fitted into the board side connector 455 by insertion, and the terminal 461 for board connection has rigidity to an extent that the terminal 461 for board connection is regarded as a rigid body. Accordingly, when the positional displacement of the harness side connector 453 is generated, the harness side connector 453 and the board side connector 455 cannot be aligned with each other.

Accordingly, it is an object of the present invention to provide a connector joining structure which can acquire both a waterproof property and a guarantee of fitting at the time of fitting a connector into a mating connector mounted on a casing.

It is another object of the present invention to provide a connector joining structure which can reduce the number of parts of a sealing member thus lowering a cost.

It is still another object of the present invention to provide a connector joining structure which includes: an outer housing mounted on a casing; an inner housing having a terminal which is connected to a terminal of a mating connector mounted on the casing; and an annular packing which ensures a sealing property between the outer housing and the inner housing whereby the connector joining structure has no possibility of lowering a waterproof performance even when the inner housing is aligned with the outer housing thus exhibiting the stable waterproof performance.

It is still another object of the present invention to provide a connector joining structure which includes: a casing; a board side connector which constitutes a mating connector; and a harness side connector (connector) which is engaged with the mating connector by fitting engagement whereby the connector can be easily aligned with the mating connector when the connector is joined to the mating connector.

A connector joining structure in accordance with some embodiments includes an outer housing mounted on a casing, an inner housing having a terminal to be connected to a terminal of a mating connector mounted in the casing, and a first packing interposed between the outer housing and the inner housing. The first packing is configured to ensure sealing property between the outer housing and the inner housing even upon a position of the inner housing with respect to the outer housing being displaced in at least one of three directions in a three-dimensional space by a predetermined amount with respect to a target value.

The first packing may be configured to ensure the sealing property by elastic deformation.

The connector joining structure may further include the casing having a first through hole, the mating connector mounted in the casing, and a second packing interposed between the casing and the outer housing. The outer housing may have a second through hole and be mounted on the casing outside the casing with the second through hole positioned inside the first through hole. The inner housing may be mounted in the outer housing with a portion of the inner housing inserted into the second through hole.

The connector joining structure may further include a bolt for fixing the outer housing to the casing. A gap may be formed between the outer housing and the casing with the bolt insufficiently fastened.

Due to the above-mentioned constitution, the connector joining structure can acquire a waterproof property and a guarantee of fitting at the time of fitting the connector to the mating connector mounted on the casing.

The first packing may have a lip portion. The lip portion may have an asymmetrical shape with respect to a center line of the lip portion and be configured to always collapse toward one side upon a change of the position of the inner housing due to a connection of the terminal of the inner housing to the terminal of the mating connector.

A gradient of an annular inclined surface inside a vertex of the lip portion and a gradient of an annular inclined surface outside the vertex may be different from each other.

The connector joining structure may further include a connector having the inner housing and the outer housing. The inner housing may include a body portion to be inserted into a through hole formed in a wall portion of the casing. The outer housing may include a fixing portion to be fixed to the wall portion and an accommodating hole extending toward the through hole and communicated with the through hole with the accommodating hole inserted into an inside of the through hole. The body portion may be insertable into the accommodating hole. The first packing may be configured to partition the outer housing and the inner housing with the first packing in close contact with surfaces of the outer housing and the inner housing facing each other. The connector joining structure may further include a second packing configured to partition one side and the other side of the wall portion with the second packing in close contact with the accommodating hole and the through hole, the second packing being formed of a single member continuous with the first packing.

Due to the above-mentioned constitution, it is unnecessary to perform the partitioning of one side and the other side of the wall portion and the partitioning of the outer housing and the inner housing using different sealing members respectively and hence, the number of parts can be reduced.

Accordingly, the partitioning of one side and the other side of the wall portion and the partitioning of the outer housing and the inner housing can be performed using one sealing member and hence, the number of parts of the sealing member can be reduced thus lowering a cost.

An opposedly-facing portion connecting the first packing and the second packing to each other and facing an edge portion of the through hole may be formed in a tapered surface.

Due to the above-mentioned constitution, it is possible to alleviate an impact generated by a contact between the edge portion of the through hole and the opposedly facing portion which is a connecting portion between the first packing and the second packing. Accordingly, peeling off of a sealing surface between the first packing and the second packing can be prevented and thus ensuring a sealing property.

The connector joining structure may further include the mating connector. The mating connector may be arranged on a side of the wall portion opposite to a side of the wall portion where the connector is arranged and include a hood portion engageable with the body portion inserted through the through hole.

Due to the above-mentioned constitution, it is possible to prevent the intrusion of water or the like into a mating connector side from a connector side by the first packing and the second packing.

A packing in accordance with some embodiments is a packing for sealing between a first member and a second member integrally mounted on the first member and includes a lip portion. The lip portion has an asymmetrical shape with respect to a center line of the lip portion and configured to always collapse toward one side upon a change of a position of the second member with respect to the first member at a time of mounting the second member on the first member.

Due to the above-mentioned constitution, in the connector joining structure which includes: an outer housing mounted on a casing; an inner housing having a terminal which is connected to a terminal of a mating connector mounted on the casing; and an annular packing provided for ensuring a sealing property between the outer housing and the inner housing, it is possible to impart a stable waterproof performance without having a possibility of lowering a waterproof performance even when the inner housing is aligned with respect to the outer housing.

A connector joining structure in accordance with some embodiments includes a casing, a board mounted on the casing, a wire being flexible and connected to the board, a mating connector connected to the board via the wire, and a connector to be joined to the mating connector with the connector mounted on the casing.

The connector joining structure may further include a packing interposed between the casing and the connector and configured to seal between the casing and the connector. The connector may be mounted on the casing with the connector positioned with respect to the casing.

Due to the above-mentioned constitution, in the connector joining structure which includes: the casing; the printed-circuit-board side connector which constitutes the mating connector; and the harness side connector (connector) which is engaged with the mating connector by fitting engagement, the connector can be easily aligned with the mating connector when the connector is joined to the mating connector.

### BRIEF DESCRIPTION OF DRAWINGS

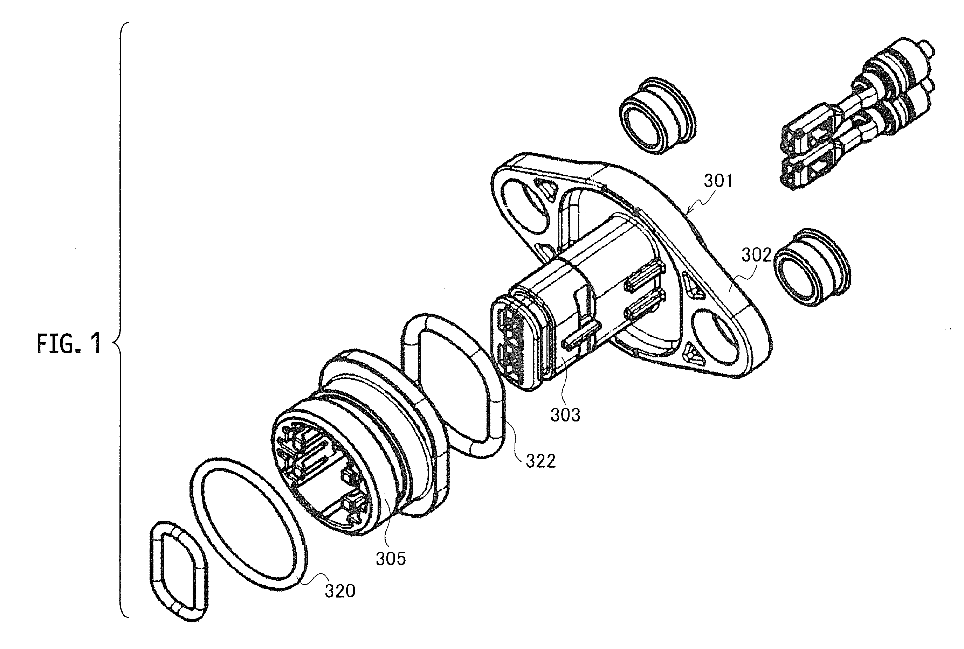

FIG. 1 is a view showing the relating connector joining structure;

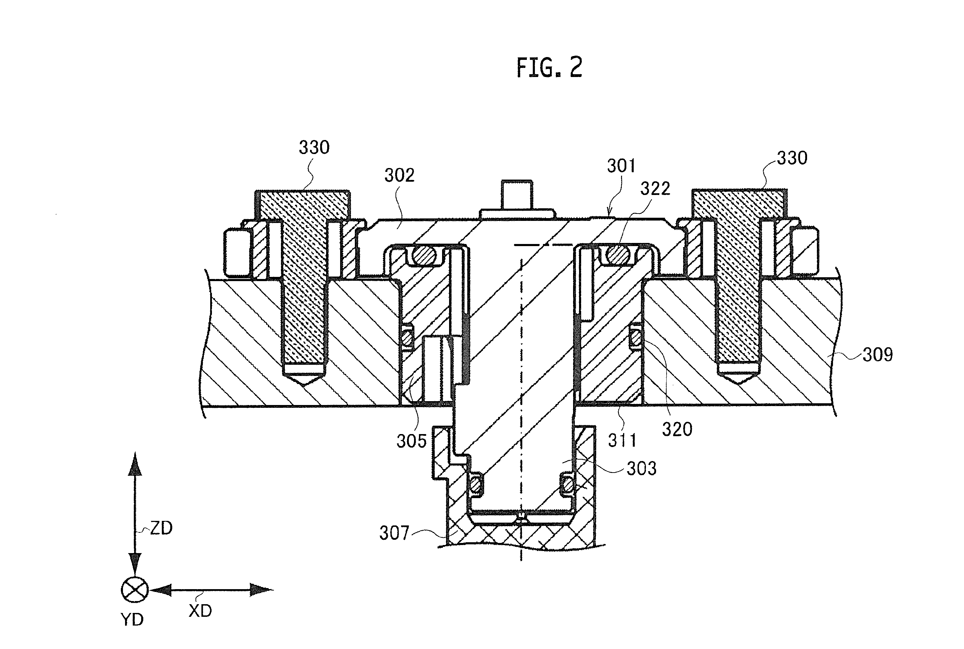

FIG. 2 is a view showing a relating connector joining structure;
FIG. 3 is a view showing the relating connector joining structure;
FIG. 4 is a perspective view of a packing used in the relating connector joining structure;
FIG. 5 is a cross-sectional view taken along a line V-V in FIG. 4;

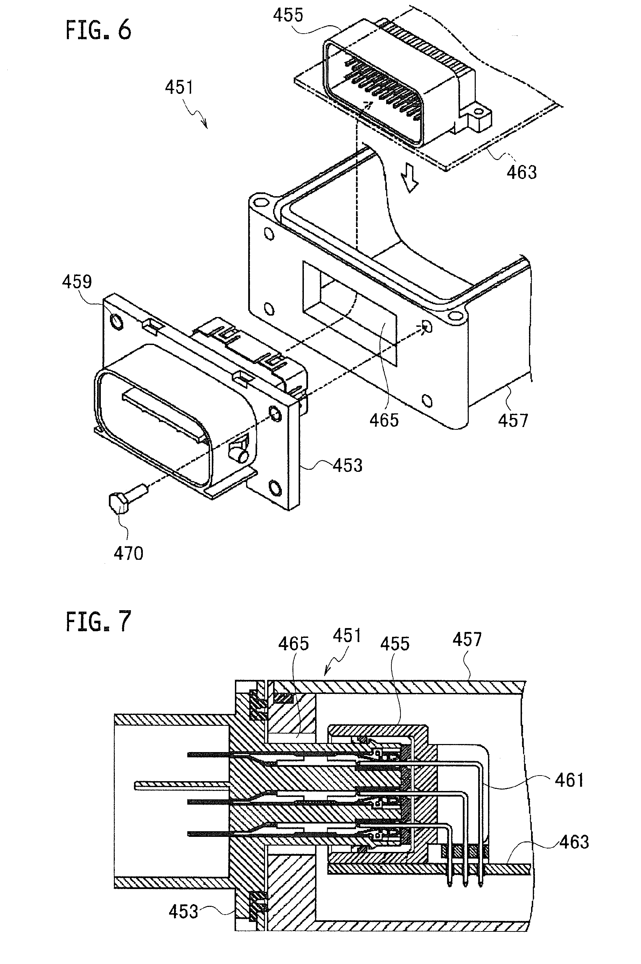

FIG. 6 is a view showing the relating connector joining structure;
FIG. 7 is a view showing the relating connector joining structure;
FIG. 8 is a perspective view showing a state where a connector and a mating connector are removed from a casing in a connector joining structure according to a first embodiment of the present invention;
FIG. 9 is a perspective view of a connector in the connector joining structure according to the first embodiment, and is also a view as viewed in the direction indicated by an arrow IX in FIG. 8;
FIG. 10 is an exploded perspective view of the connector in the connector joining structure according to the first embodiment;
FIG. 11 is a perspective view showing a state before the connector is mounted on the casing in the connector joining structure according to the first embodiment;
FIG. 12 is a cross-sectional view taken along a line XII-XII in FIG. 11;
FIG. 13 is a perspective view showing a state where the mounting of the connector on the casing is finished in the connector joining structure according to the first embodiment;
FIG. 14A is a view showing a state where there is no positional displacement of an inner connector with respect to an outer connector;
FIG. 14B is a view showing a state where there is a positional displacement of the inner connector with respect to the outer connector, and the positional displacement is absorbed;
FIG. 15A is a cross-sectional view taken along a line XVA-XVA in FIG. 13;
FIG. 15B is an enlarged view of an portion indicated by a symbol XVB in FIG. 15A;
FIG. 16 is a view as viewed in the direction indicated by an arrow XVI in FIG. 13;
FIG. 17 is a view corresponding to FIG. 16, and is also a view showing a state where a gap is formed between the outer connector and the casing;
FIGS. 18A to 18F are views showing a cross-sectional shape of a packing;
FIG. 19 is a perspective view showing a state where a connector, a mating connector and a board are removed from a casing in a connector joining structure according to a second embodiment of the present invention;
FIG. 20 is a perspective view of the connector in the connector joining structure according to the second embodiment, and is also a view as viewed in the direction indicated by an arrow XX in FIG. 19;
FIG. 21 is a perspective view showing a state before a terminal is mounted on the mating connector in the connector joining structure according to the second embodiment;
FIG. 22A is a perspective view showing a state where the mounting of the terminal on the mating connector is finished in the connector joining structure according to the second embodiment;
FIG. 22B is a view as viewed in the direction indicated by an arrow XXIIB in FIG. 22A;
FIG. 23 is a perspective view showing a state before the connector is mounted on the casing in the connector joining structure according to the second embodiment;
FIG. 24 is a cross-sectional view taken along a line XXIV-XXIV in FIG. 23;
FIG. 25 is a perspective view showing a state where the mounting of the connector on the casing is finished in the connector joining structure according to the second embodiment;
FIG. 26 is a cross-sectional view taken along a line XXVI-XXVI in FIG. 25;
FIG. 27 is a perspective view showing a state where a connector, a mating connector and a board are removed from a casing in a connector joining structure according to a third embodiment of the present invention;
FIG. 28 is a perspective view of the connector in the connector joining structure according to the third embodiment, and is also a view as viewed in the direction indicated by an arrow XXVIII in FIG. 27;
FIG. 29 is a perspective view showing a state before the connector is mounted on the casing in the connector joining structure according to the third embodiment;
FIG. 30A is a perspective view showing a state where the mounting of a terminal on the mating connector is finished in the connector joining structure according to the third embodiment;
FIG. 30B is a view as viewed in the direction indicated by an arrow XXXB in FIG. 30A;
FIG. 31 is a perspective view showing a state before the connector is mounted on the casing in the connector joining structure according to the third embodiment;
FIG. 32 is a cross-sectional view taken along a line XXXII-XXXII in FIG. 31;
FIG. 33 is a perspective view showing a state where the mounting of the connector on the casing is finished in the connector joining structure according to the third embodiment;
FIG. 34 is a cross-sectional view taken along a line XXXIV-XXXIV in FIG. 33;
FIG. 35 is an exploded perspective view of a connector according to a fourth embodiment of the present invention;
FIG. 36A is a perspective view showing the connector joining structure according to the fourth embodiment at the time of assembling the connector to the connector joining structure;
FIG. 36B is a perspective view of the connector joining structure according to the fourth embodiment;
FIG. 37 is a cross-sectional view showing the connector joining structure according to the fourth embodiment at the time of assembling the connector to the connector joining structure;
FIG. 38A is a cross-sectional view showing the connector joining structure according to the fourth embodiment in the course of assembling the connector to the connector joining structure;
FIG. 38B is an enlarged view of an essential part in FIG. 38A;
FIG. 39A is a cross-sectional view of the connector joining structure according to the fourth embodiment;
FIG. 39B is an enlarged view of an essential part in FIG. 39A;
FIG. 40 is a perspective view of the connector in the connector joining structure according to the fourth embodiment;
FIG. 41 is an exploded perspective view of the connector in the connector joining structure according to the fourth embodiment;
FIG. 42A is a perspective view of a sealing member in the connector joining structure according to the fourth embodiment;
FIG. 42B is a cross-sectional view of the sealing member in the connector joining structure according to the fourth embodiment;
FIG. 43A is a front view showing a state where the sealing member is assembled to the connector of the connector joining structure according to the fourth embodiment; and
FIG. 43B is a front view showing a state where a positional displacement of a mating connector with respect to the casing is absorbed by the sealing member from a state shown in FIG. 43A.

### DETAILED DESCRIPTION

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

Description will be hereinbelow provided for an embodiment of the present invention by referring to the drawings. It should be noted that the same or similar parts and components throughout the drawings will be denoted by the same or similar reference signs, and that descriptions for such parts and components will be omitted or simplified. In addition, it should be noted that the drawings are schematic and therefore different from the actual ones.

In the drawings, symbols "XD", "YD", "ZD" indicate the X direction, the Y direction and the Z direction, respectively.

### First embodiment

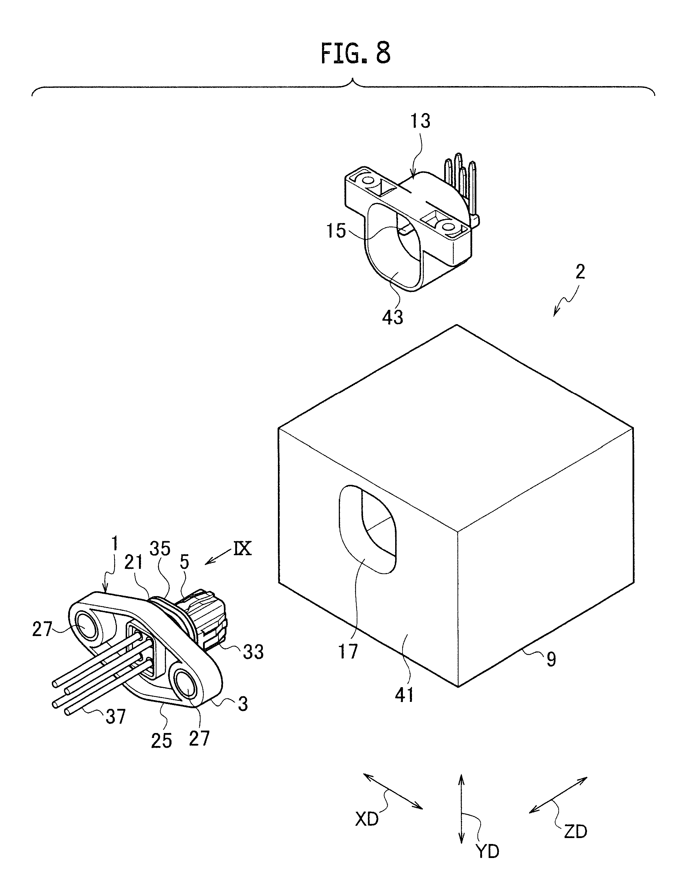

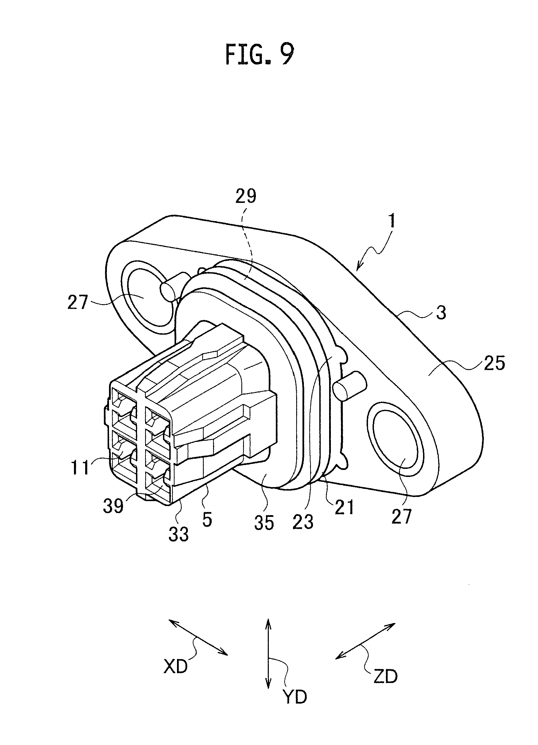

The first embodiment of the present invention is described in detail by reference to FIG. 8 to 18F. As shown in FIG. 8 to FIG. 10 and the like, a connector joining structure 2 according to the first embodiment of the present invention includes: a connector 1 (female connector, for example); a casing 9; and a mating connector 13.

As shown in FIG. 8 to FIG. 10 and the like, the connector 1 includes: an outer housing (equipment waterproof member) 3; an inner housing (terminal joining member 5); and a first packing (inner packing) 7.

The outer housing 3 is made of an insulating synthetic resin, for example, and is integrally mounted on the casing 9.

The inner housing 5 is made of an insulating synthetic resin, for example, and is formed as a separate body from the outer housing 3. Terminals (for example, female terminals) 11 are formed on the inner housing 5. The terminals 11 are configured to be connected to terminals (for example, male terminals) 15 of the mating connector (for example, male connector) 13 which is integrally mounted in the casing 9.

The inner housing 5 is positioned with respect to the mating connector 13 and the outer housing 3 and is integrally mounted on the mating connector 13 and the outer housing 3 so that the female terminals 11 are connected to the male terminals 15 of the mating connector 13.

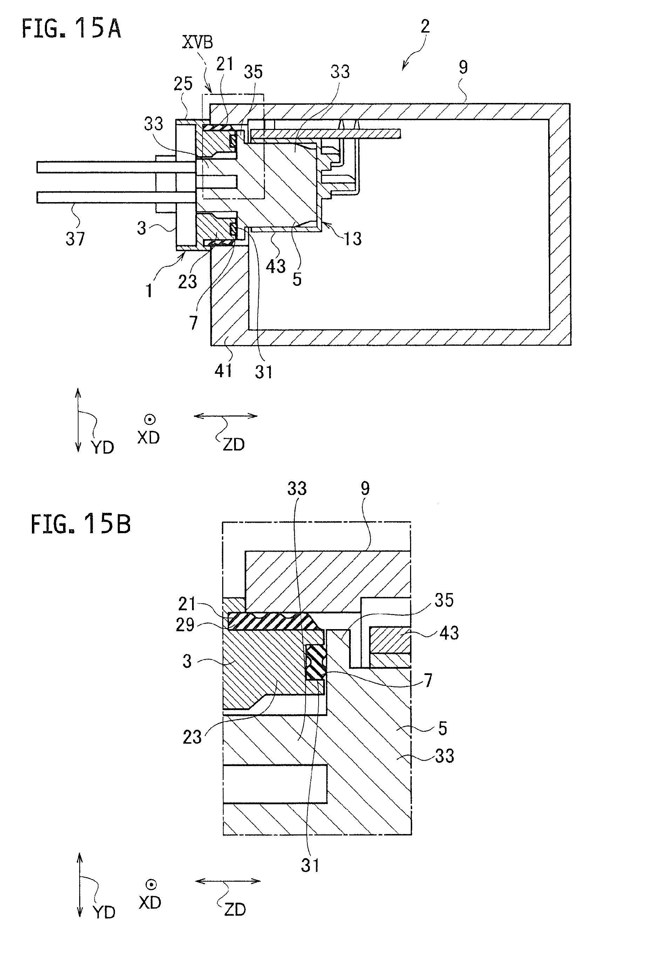

The first packing (first seal packing) 7 is formed using an elastic body having an insulating property such as rubber or the like, and is formed into an annular shape. As shown in FIGS. 15A, 15B and the like, the first packing 7 is interposed between the outer housing 3 and the inner housing 5 for ensuring a sealing property between the outer housing 3 and the inner housing 5.

In this embodiment, even when a positional displacement of the inner housing 5 with respect to the outer housing 3 occurs, a sealing property (sealing function) between the outer housing 3 and the inner housing 5 is ensured.

A positional displacement of the inner housing 5 with respect to the outer housing 3 occurs when the terminals 11 of the inner housing 5 are connected to the terminals 15 of the mating connector 13. The positional displacement occurs when the inner housing 5 is moved in at least one of three directions (the directions consisting of the X direction, the Y direction and the Z direction which are orthogonal to each other) in a three-dimensional space (three-dimensional physical space) by a predetermined amount with respect to a target value of a position of the inner housing 5.

To describe this positional displacement in more detail, even when the position of the inner housing 5 is displaced with respect to the outer housing 3 in at least one of the X direction, the Y direction and the Z direction within a predetermined range, the inner packing (inner seal packing) 7 can ensure a sealing function between the outer housing 3 and the inner housing 5. That is, water or the like cannot pass through between the outer housing 3 and the inner housing 5.

For example, the inner packing 7 can ensure a sealing function between the outer housing 3 and the inner housing 5 in the following cases. That is, the sealing function is ensured in the case where the position of the inner housing 5 is displaced with respect to the outer housing 3 only in the X direction within a predetermined range, in the case where the position of the inner housing 5 is displaced with respect to the outer housing 3 only in the Y direction within a predetermined range, in the case where the position of the inner housing 5 is displaced with respect to the outer housing 3 only in the Z direction within a predetermined range, in the case where the position of the inner housing 5 is displaced with respect to the outer housing 3 in the X direction and the Y direction within a predetermined range, the case where the position of the inner housing 5 is displaced with respect to the outer housing 3 in the Y direction and the Z direction within a predetermined range, the case where the position of the inner housing 5 is displaced with respect to the outer housing 3 in the Z direction and the X direction within a predetermined range, or in the case where the position of the inner housing 5 is displaced with respect to the outer housing 3 in the X direction, the Y direction and the Z direction within a predetermined range.

Further, even when a posture (position) of the inner housing 5 with respect to the outer housing 3 is displaced about the predetermined axis (A axis) extending in the X direction, the predetermined axis (B axis) extending in the Y direction, or the predetermined axis (C axis) extending in the Z direction within a predetermined range, the inner packing 7 can ensure a sealing function between the outer housing 3 and the inner housing 5.

When the position of the inner housing 5 with respect to the outer housing 3 is displaced by a predetermined amount in at least one of three directions (also about the A axis, the B axis and/or the C axis depending on cases) in a three-dimensional space with respect to a target value, a sealing property between the outer housing 3 and the inner housing 5 is ensured only by the elastic deformation of the inner packing 7.

The mating connector 13 is mounted in the casing 9. A through hole 17 is formed in the casing 9, and a through hole 19 is formed in the outer housing 3.

The outer housing 3 is mounted on the casing 9 outside the casing 9 in a state where the through hole 19 is positioned inside the through hole 17 formed in the casing 9. The inner housing 5 is mounted in the outer housing 3 such that a portion of the inner housing 5 is inserted into the through hole 19 formed in the outer housing 3.

To ensure a sealing property between the casing 9 and the outer housing 3, an annular second packing (outer packing, outer seal packing) 21 is interposed between the casing 9 and the outer housing 3. In the same manner as the inner packing 7, the outer packing 21 is also formed using an elastic body having an insulating property such as rubber or the like, and is formed into an annular shape.

The connector 1, the casing 9, the mating connector 13 and the like are described in further details.

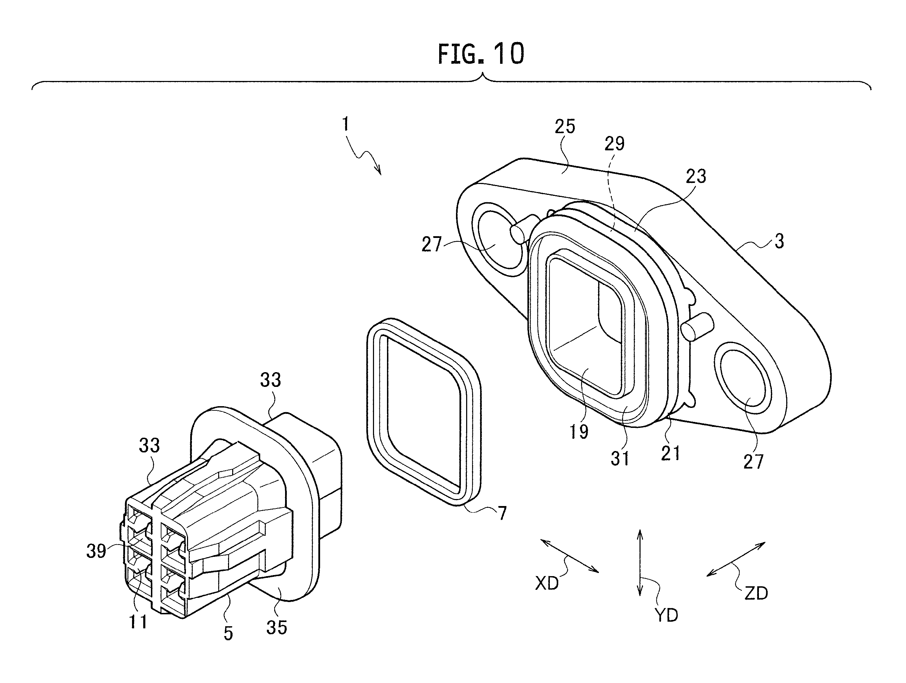

As shown in FIG. 10 and the like, the outer housing 3 of the connector 1 includes: a body portion 23 formed into a rectangular cylindrical shape; and flange portions 25, for example. The extending direction of the center axis of the cylindrical body portion 23 and the Z direction agree with each other. The through hole 19 formed in the outer housing 3 is defined by an inner space of the cylindrical body portion 23.

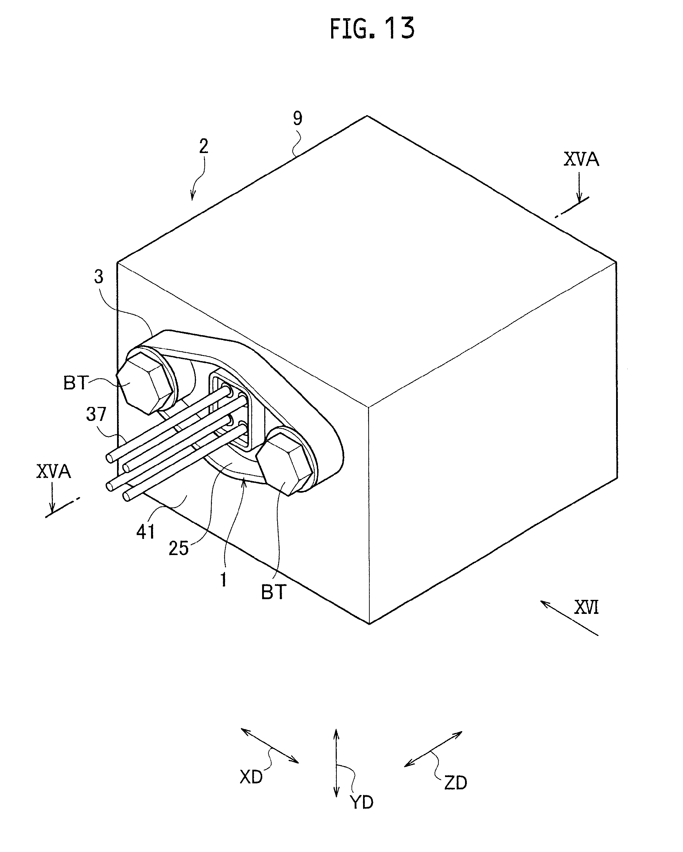

The flange portions 25 are formed into a flat plate shape having a predetermined thickness, and project from both sides of an outer periphery of the body portion 23 in the substantially X direction on one end portion side of the body portion 23 in the Z axis direction. The thickness direction of the flange portions 25 projecting from the outer periphery of the body portion 23 is the Z direction. A through hole 27 which penetrates the flange portion 25 in the thickness direction is formed in each of the flange portions 25 forming a pair. The through holes 27 are used at the time of mounting the outer housing 3 on the casing 9 using fastening tools such as bolts BT (see FIG. 13).

When fastening of the bolts BT is insufficient, as shown in FIG. 17, a gap 313 is formed. When the bolts BT are properly fastened, as shown in FIG. 15A and FIG. 16, the flange portion 25 is brought into close contact with the casing 9.

The body portion 23 of the outer housing 3 projects from the other ends of the flange portions 25 in the Z axis direction. An annular cut-away portion (or groove) 29 for mounting the rectangular annular outer packing 21 therein is formed on the outer periphery of the projecting body portion 23. By inserting the outer packing 21 into the annular cut-away portion 29, the outer packing 21 is mounted in the outer housing 3. In a state where the outer packing 21 is mounted in the outer housing 3, an outer diameter of the outer packing 21 is set slightly larger than an outer diameter of the body portion 23.

An annular groove 31 for mounting the rectangular annular inner packing 7 therein is formed on the body portion 23 of the outer housing 3. The groove 31 is formed on a distal end of the body portion 23 projecting from the flange portions 25 (for example, the groove 31 is formed of a recessed portion which is recessed toward a flange portion 25 side from a distal end surface). An inner diameter of the groove 31 is larger than an inner diameter of the body portion 23 (a diameter of the through hole 19), and an outer diameter of the groove 31 is smaller than an outer diameter of the body portion 23.

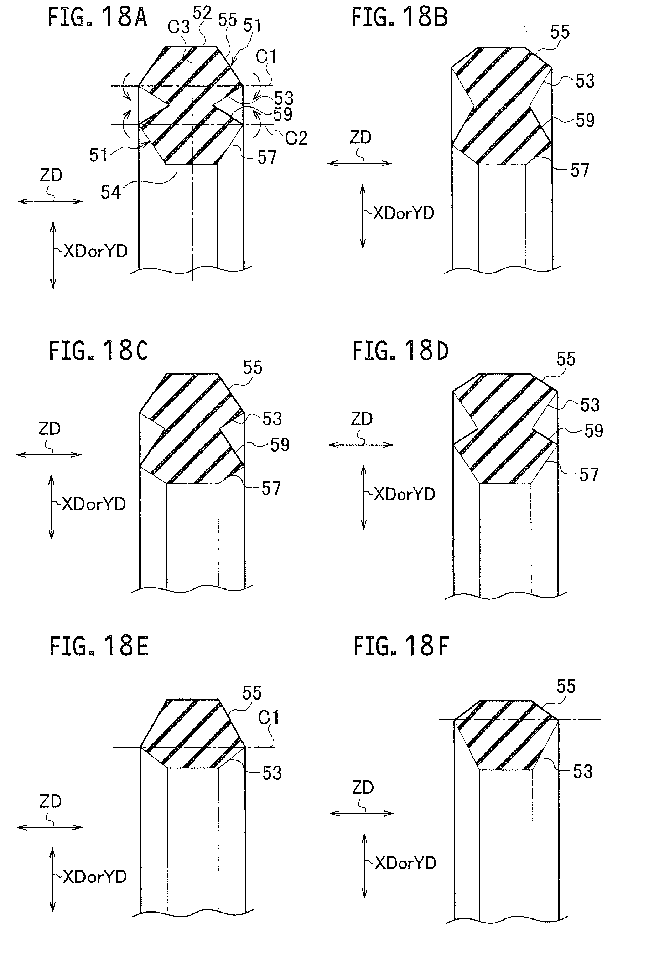

In a state where the inner packing 7 is mounted in the groove 31 formed on the body portion 23 of the outer housing 3, the inner packing 7 slightly projects from the distal end of the body portion 23. The projecting portion forms a portion of the inner packing 7, and has a rectangular annular shape. For example, the projecting portion is formed of a lip portion 51 described later (see FIG. 18A; the lip portion 51 on one side in the Z direction), and the lip portion 51 also has a rectangular annular shape as a whole.

The inner housing 5 of the connector 1 includes: a body portion 33 formed into a rectangular cylindrical shape; and a flange portion 35, for example. The extending direction of the center axis of the cylindrical body portion 33 and the Z direction agree with each other. Cavities 39 are formed in the cylindrical body portion 33, and the female terminals 11 from which electric wires 37 extend are inserted into and mounted in the cavities 39. The electric wires 37 are mounted on the female terminals 11 by caulking or the like.

The flange portion 35 is formed into a rectangular flat plate shape with a predetermined thickness. The flange portion 35 projects in the X direction and the Y direction from the whole outer periphery of the body portion 33 at an intermediate portion in the Z axis direction. The thickness direction of the flange portion 35 projecting from the outer periphery of the body portion 33 is the Z direction.

Due to such a constitution, the body portion 33 of the inner housing 5 projects from one end and the other end of the flange portion 35 in the Z axis direction.

An outer diameter of the body portion 33 of the inner housing 5 is smaller than an inner diameter of the through hole 19 formed in the body portion 23 of the outer housing 3, and an outer diameter of the flange portion 35 of the inner housing 5 is equal to the outer diameter of the body portion 23 of the outer housing 3, or slightly larger than the outer diameter of the body portion 23.

In the inner housing 5 where the female terminals 11 to which the wires 37 are mounted are provided, the electric wires 37 extend from one end of the body portion 33 in the Z direction. In a state where the inner housing 5 from which the electric wires 37 extend is mounted in the outer housing 3, one end portion of the body portion 33 in the Z axis direction (a portion of the body portion 33 projecting from the flange portion 35) is inserted into the through hole 19 formed in the outer housing 3, and the electric wires 37 extend from one end of the body portion 33.

In a state where the inner housing 5 is mounted in the outer housing 3, the inner housing 5 is movable with respect to the outer housing 3 in the X direction or in the Y direction (movable within a range of tolerance between the outer diameter of the body portion 33 and a diameter of the through hole 19).

In a state where the inner housing 5 is mounted in the outer housing 3, the flange portion 35 of the inner housing 5 is in contact with the inner packing 7 mounted on the outer housing 3 (see FIG. 15B), and the flange portion 35 and the body portion 23 of the outer housing 3 are slightly spaced apart from each other in the Z direction so that the inner housing 5 is movable in the Z direction and is rotatable about the A axis, the B axis or the C axis with respect to the outer housing 3 due to elastic deformation of the inner packing 7. The range of the above-mentioned movement and rotation of the inner housing 5 with respect to the outer housing 3 is restricted by the constitution that the flange portion 35 is in contact with the inner packing 7 with a predetermined pressing force (a pressing force at which a sealing property can be maintained) and the constitution that the flange portion 35 is brought into contact with the distal end of the body portion 23 of the outer housing 3.

An outer shape and an inner shape of the casing 9 are formed into a rectangular parallelepiped shape, for example. The through hole 17 is formed in one wall portion 41 having a flat plate shape which constitutes the casing 9, and the through hole 17 penetrates the wall portion 41 in the thickness direction (Z direction).

An inner diameter of the through hole 17 is substantially equal to the outer diameter of the body portion 23 of the outer housing 3. In a state where the outer housing 3 is mounted on the casing 9, the body portion 23 of the outer housing 3 is fitted into the through hole 17, and the flange portions 25 of the outer housing 3 are brought into contact with the wall portion 41 outside the casing 9 so that the outer housing 3 is positioned with respect to the casing 9 in the X direction, in the Y direction and in the Z direction.

In a state where the outer housing 3 is mounted on the casing 9, the outer packing 21 collapses due to elastic deformation thereof so that a sealing property between the casing 9 and the outer housing 3 is ensured.

A portion of the inner housing 5 is positioned in the inside of the casing 9 and other portions of the inner housing 5 are positioned in the inside of the through hole 19 formed in the outer housing 3. The electric wires 37 extending from the inner housing 5 pass through the through hole 19 formed in the outer housing 3 and extend to the outside of the casing 9.

The male terminals 15 are mounted on the mating connector 13. The male terminals 15 are surrounded by a cylindrical hood portion 43. The mating connector 13 is integrally mounted on the casing 9 by fastening tools such as bolts or the like (not shown in the drawing) in the inside of the casing 9 such that the hood portion 43 faces a through hole 17 side. An inner diameter of the hood portion 43 is substantially equal to the outer diameter of the body portion 33 of the inner housing 5.

In a state where the mating connector 13 is mounted on the casing 9, it is intended (desirable) that the center axis of the hood portion 43 (the center axis extending in the Z direction) and the center axis of the through hole 17 formed in the casing 9 (the center axis extending in the Z direction) agree with each other in the X direction and in the Y direction. However, in the actual structure, the center axis of the hood portion 43 and the center axis of the through hole 17 of the casing 9 are slightly displaced from each other due to an error in assembling or the like. There may also be a case where the center axis of the hood portion 43 and the center axis of the through hole 17 of the casing 9 are slightly displaced from each other in the Z direction or about the A axis, the B axis or the C axis.

In a state where the connector 1 is mounted on the casing 9 on which the mating connector 13 is mounted so as to connect the terminal 11 of the connector 1 to the terminal 15 of the mating connector 13, the body portion 33 of the inner housing 5 (a portion of the body portion on a side opposite to a side of the body portion from which the electric wires 37 extend) is fitted into the hood portion 43 of the mating connector 13. That is, the inner housing 5 is positioned with respect to the mating connector 13 by making the inner housing 5 aligned with an opening position of the mating connector 13.

Due to such positioning of the inner housing 5 with respect to the mating connector 13 as described above, the slight positional displacement of the inner housing 5 with respect to the outer housing 3 occurs (the positional displacement in the X direction and the Y direction may include the positional displacement in the Z direction or about the A axis, the B axis or the C axis). However, even when such positional displacement occurs, the inner packing 7 is elastically deformed so that a sealing property between the outer housing 3 and the inner housing 5 is maintained.

Here, the first packing (inner packing) 7 is described in detail.

As shown in FIG. 18A, the inner packing 7 has the lip portions 51. Each lip portion 51 has an asymmetrical shape with respect to the center line of the lip portion 51 (center lines C1, C2 which pass a vertex of the lip portion 51). FIG. 18A shows a cross section of the annular inner packing 7 (a cross section of the inner packing 7 in a plane orthogonal to the extending direction of an annular shape). The center axis (not shown in the drawing) of the annular inner packing 7 is positioned below the drawing shown in FIG. 18A, and extends in the lateral direction in FIG. 18A.

The lip portion 51 has the above-mentioned asymmetrical shape for making the lip portion 51 always collapse toward one side when the position of the inner housing 5 is changed due to the connecting of the terminal 11 of the inner housing 5 to the terminal 15 of the mating connector 13 (when there is the positional displacement from the target position due to the positioning of the inner housing 5 with respect to the male terminals 15 or the outer housing 3) irrespective of the direction (the plus or minus direction in the X direction, the plus or minus direction in the Y direction) of the change in the position of the inner housing 5.

For example, the annular first packing 7 provides sealing between the outer housing 3 and the inner housing 5 such that the annular first packing 7 is brought into contact with the outer housing 3 and the inner housing 5 thus collapsing the lip portions 51 due to elastic deformation by reaction forces from the outer housing 3 and the inner housing 5. The first packing 7 may be configured such that the lip portion 51 is formed on either one of a right side and a left side of the first packing 7 in FIG. 18A so that the lip portion 51 is brought into contact with the outer housing 3 or the inner housing 5.

As shown in FIG. 18A, the lip portion 51 is formed such that the configuration of a gradient (for example, an absolute value of the gradient) of an annular inclined surface 53 inside a vertex (center line C1) and the configuration of a gradient (for example, an absolute value of the gradient) of an annular inclined surface 55 outside the vertex (center line C1) differ from each other.

As shown in FIG. 18A, the lip portion 51 is formed such that the configuration of a gradient (for example, an absolute value of the gradient) of an annular inclined surface 57 inside a vertex (center line C2) and the configuration of a gradient (for example, an absolute value of the gradient) of an annular inclined surface 59 outside the vertex (center line C2) differ from each other. The vertex (center line C2) is positioned inside the vertex (center line C1).

The first packing 7 is described in further details. In the actual structure, the center line C1 is formed of a cylindrical face along a ring of the annular first packing 7. The center line C2 is also formed of a cylindrical face. The center line C2 is positioned inside the center line C1, and is arranged parallel to the center line C1.

The lip portion 51 on one side in the Z direction (for example, the right side in FIG. 18A) projects toward one end side in the Z direction at a predetermined gradient from the outer periphery 52 of the first packing 7 to the center line C1. Due to such formation of the lip portion 51, the inclined surface 55 is formed. The lip portion 51 on one side in the Z direction is recessed toward the other end side in the Z direction at a predetermined gradient from the center line C1 to a position between the center line C1 and the center line C2 (center). Due to such formation of the lip portion 51, the inclined surface 53 is formed. The gradient of the inclined surface 53 is set larger than the gradient of the inclined surface 55.

The lip portion 51 on one side in the Z direction projects toward one end side in the Z direction at a predetermined gradient from the position between the center line C1 and the center line C2 (center) to the center line C2. Due to such formation of the lip portion 51, the inclined surface 59 is formed. A gradient (an absolute value of the gradient) of the inclined surface 59 is set equal to the gradient (an absolute value of the gradient) of the inclined surface 53. The lip portion 51 on one side in the Z direction is recessed toward the other end side in the Z direction at a predetermined gradient from the center line C2 to an inner periphery 54 of the first packing 7. Due to such formation of the lip portion 51, the inclined surface 57 is formed. A gradient (an absolute value of the gradient) of the inclined surface 57 is equal to the gradient (an absolute value of the gradient) of the inclined surface 55.

The lip portion 51 on the other side in the Z direction has the shape symmetrical with the shape of the lip portion 51 on one side in the Z direction with respect to a center face C3 of the first packing 7 in the Z axis direction.

In the connector 1, the lip portions 51 of the first packing 7 are configured to always collapse toward one side (toward the center side between the center line C1 and the center line C2; inclined surfaces 53, 59 side) between the outer housing 3 and the inner housing 5 as indicated by arrows in FIG. 18A.

The lip portion 51 may have the shape shown in FIGS. 18B to 18F.

In FIG. 18B, the gradients of the inclined surfaces 55, 57 are set larger than the gradients of the inclined surfaces 53, 59. In FIG. 18C, the gradient of the inclined surface 55 and the gradient of the inclined surface 59 are set equal to each other. The gradient of the inclined surface 53 and the gradient of the inclined surface 57 are set equal to each other. The gradients of the inclined surfaces 53, 57 are set larger than the gradients of the inclined surfaces 55, 59. In FIG. 18D, the gradient of the inclined surface 55 is set equal to the gradient of the inclined surface 59, the gradient of the inclined surface 53 is set equal to the gradient of the inclined surface 57, and the gradients of the inclined surfaces 55, 59 are set larger than the gradients of the inclined surfaces 53, 57.

Although the lip portions 51 are formed doubly in FIGS. 18A to 18D, (the cylindrical center line C2 being disposed inside the cylindrical center line C1), the lip portion 51 may be formed singly as shown in FIG. 18E and FIG. 18F. In FIG. 18E, the gradient of the inclined surface 53 is set larger than the gradient of the inclined surface 55. In FIG. 18F, the gradient of the inclined surface 55 is set larger than the gradient of the inclined surface 53.

Next, the mounting operation of the connector 1 is described.

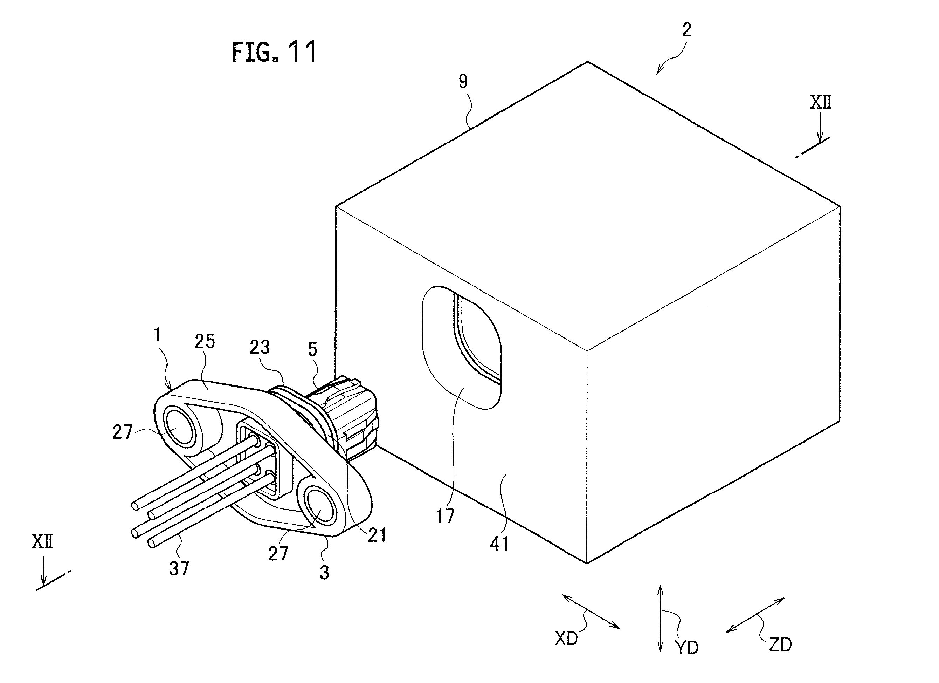

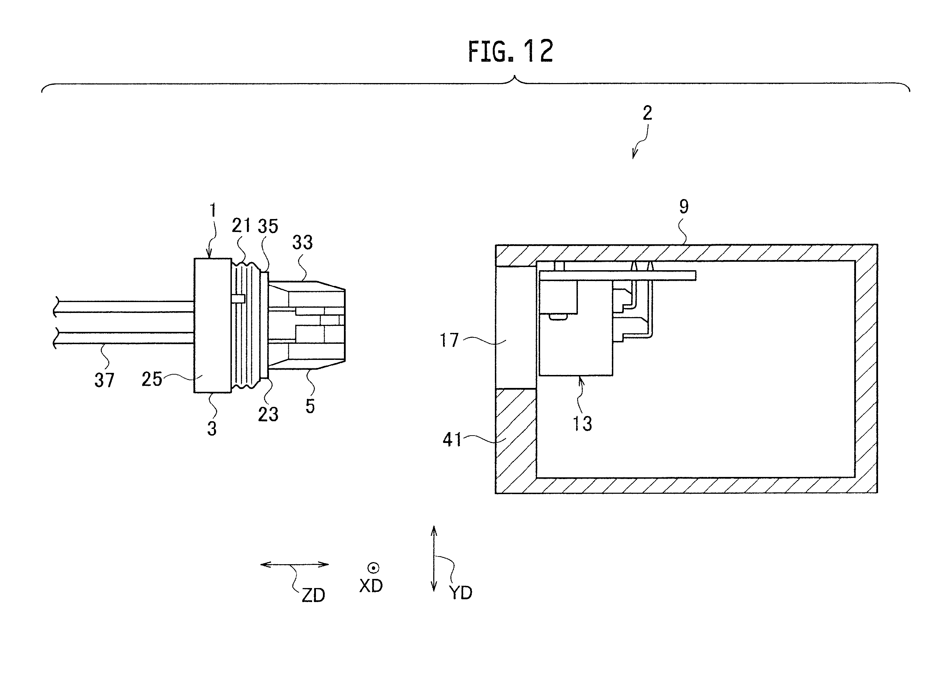

As shown in FIG. 11, FIG. 12 and the like, the mating connector 13 is disposed in the casing 9 in an initial state, while the outer packing 21, the inner packing 7 and the inner housing 5 are mounted on the outer housing 3.

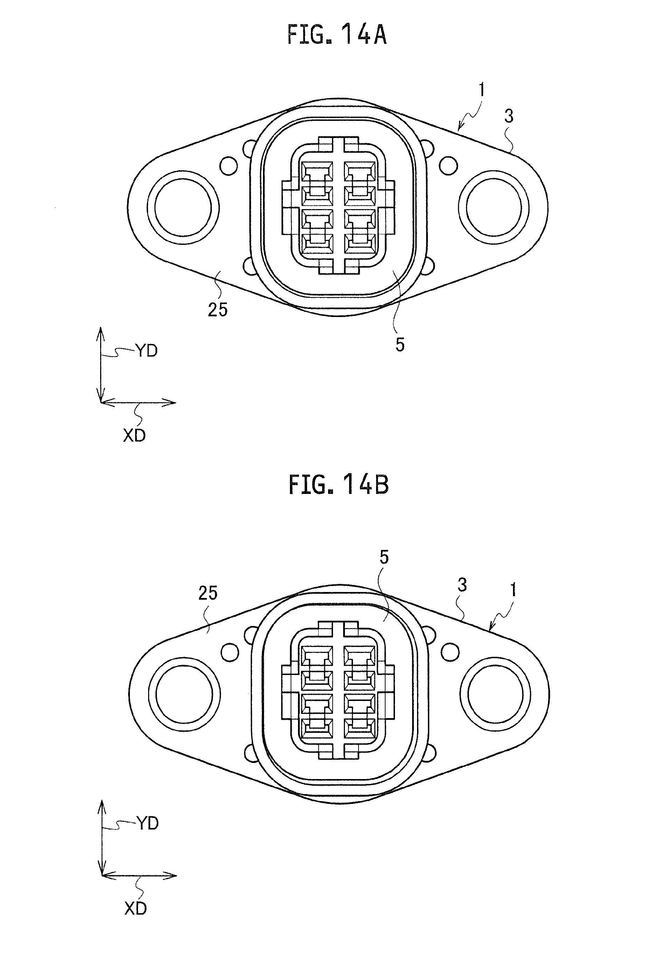

In the above-mentioned initial state, the body portion 33 of the inner housing 5 projecting from the outer housing 3 and the body portion 23 projecting from the flange portion 25 of the outer housing 3 are inserted into the through hole 17 formed in the casing 9, and the female terminals 11 of the connector 1 are connected to the male terminals 15 of the mating connector 13 (see FIG. 13, FIGS. 15A, 15B or the like). In connecting the female terminals 11 of the connector 1 to the male terminals 15 of the mating connector 13 in this manner, the inner housing 5 is positioned with respect to the mating connector 13, and the inner housing 5 is slightly moved with respect to the outer housing 3 (see FIGS. 14A, 14B or the like). Simultaneously, the lip portion 51 collapses in the directions indicated by arrows in FIG. 18A.

Subsequently, the outer housing 3 is fixed to the casing 9 using the bolts BT. At this stage of operation, when fastening of the bolts BT is insufficient, the gap 313 is formed in the Z direction between the outer housing 3 (flange portion 25) and the casing 9 (see FIG. 17).

According to the connector joining structure 2, the lip portions 51 have an asymmetrical shape with respect to the center lines C1, C2, and the inner housing 5 is positioned when the connector 1 is joined to the mating connector 13. Accordingly, even when the position of the inner housing 5 is changed with respect to the outer housing 3, the lip portions 51 of the inner packing 7 positioned between the outer housing 3 and the inner housing 5 collapse toward one side and hence, lowering of waterproof property due to the inner packing 7 does not occur thereby a waterproof property is stabilized.

According to the connector joining structure 2, the gradients of the annular inclined surfaces 53, 57 inside the vertex of the lip portion 61 and the gradients of the annular inclined surfaces 55, 59 outside the vertex of the lip portion 51 differ from each other. Accordingly, it is possible to stabilize a waterproof property with the lip portions 51 having a simple configuration.

Further, the connector 1 is divided into the outer housing 3 and the inner housing 5 so that, even when the position of the inner housing 5 is displaced with respect to the outer housing 3 in a three-dimensional space by a predetermined amount with respect to a target value, it is possible to ensure a sealing property between the outer housing 3 and the inner housing 5 by the inner packing 7. Accordingly, even when the position of the inner housing 5 is displaced at the time of engaging the connector 1 (inner housing 5) with the mating connector 13 mounted in the casing 9 by fitting engagement, it is possible to prevent the formation of a gap in the connector 1 and thus acquiring a waterproof property and the guarantee of fitting engagement including the guarantee of connection between the terminals 11, 15.

According to the connector 1, the connector 1 is configured such that a sealing property between the outer housing 3 and the inner housing 5 is ensured by elastic deformation of the inner packing 7. Accordingly, the constitution of the connector 1 is simple.

According to the connector 1, the outer housing 3 is mounted on the casing 9 outside the casing 9, and the inner housing 5 is mounted on the outer housing 3 by inserting a portion of the inner housing 5 into the through hole 19 formed in the outer housing 3. Accordingly, the outer packing 21 can be inserted between the casing 9 and the outer housing 3 and hence, the intrusion of water or the like into the inside of the casing 9 can be surely prevented.

According to the connector 1, the inner housing 5 is movable with respect to the outer housing 3 within a predetermined range. Accordingly, even when a positional displacement of the inner housing 5 in the Z direction occurs due to the connection between the terminals 11 and 15, provided that the fastening of the bolts BT is properly performed for fixing the outer housing 3 to the casing 9, there is no possibility that the gap 313 shown in FIG. 17 is formed (that is, as shown in FIG. 15A and FIG. 16, a gap is not formed in the Z direction between the casing 9 and the outer housing 3). Accordingly, by only confirming that the gap is not formed, it is possible to easily find out whether or not fastening of the bolts BT for fixing the outer housing 3 to the casing 9 is insufficient thus acquiring the guarantee of fitting engagement.

In the above-mentioned connector joining structure 2, the connector 1 is divided into the outer housing 3 and the inner housing 5, and sealing is provided between the outer housing 3 and the inner housing 5 by the inner packing 7. However, the connector 1 may be formed of an integral body without being divided, and a gap formed between the connector 1 and the casing 9 may be sealed by a packing formed in the substantially same manner as the inner packing 7. In this case, an inner diameter of the through hole 17 formed in the casing 9 is set larger than an outer diameter of an inserting portion of the connector 1 (a portion which corresponds to the body portion 23 of the above-mentioned outer housing 3 projecting from the flange portion 25). Due to such a constitution, at the time of mounting the connector 1 on the casing 9, the connector 1 is movable with respect to the casing 9 in the X direction and in the Y direction (movable within a range of tolerance between the outer diameter of the body portion of the connector and the inner diameter of the through hole of the casing).

The first packing 7 is a packing which provides sealing between a first member and a second member integrally mounted on the first member, and is an example of a packing which is configured such that a lip portion has an asymmetrical shape with respect to the center line thereof and hence, even when the position of the second member is changed with respect to the first member at the time of mounting the second member on the first member, the lip portion always collapses toward one side irrespective of the direction of a change in the position of the second member.

### Second embodiment

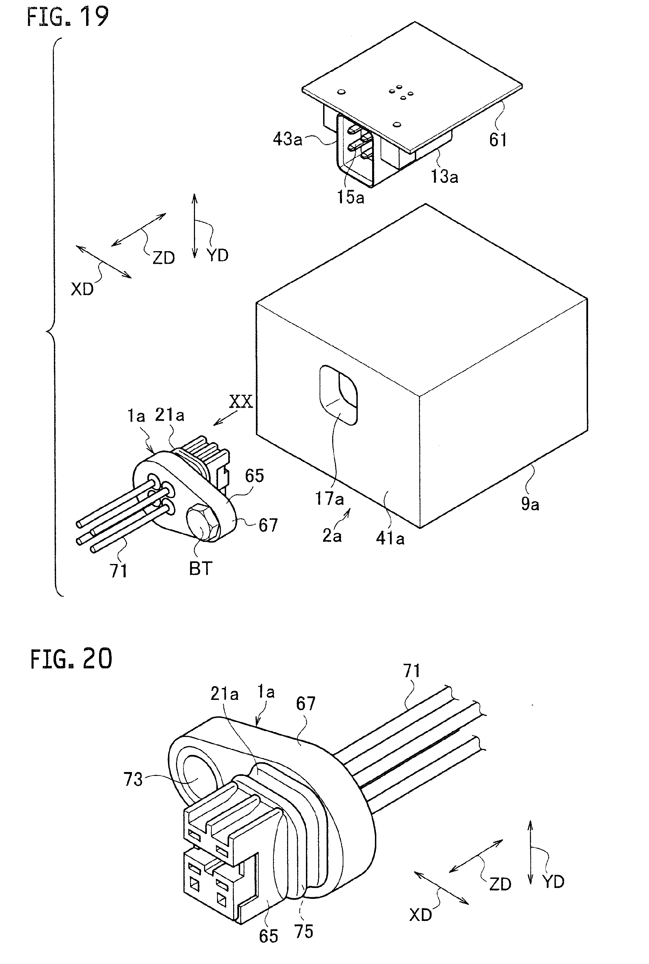

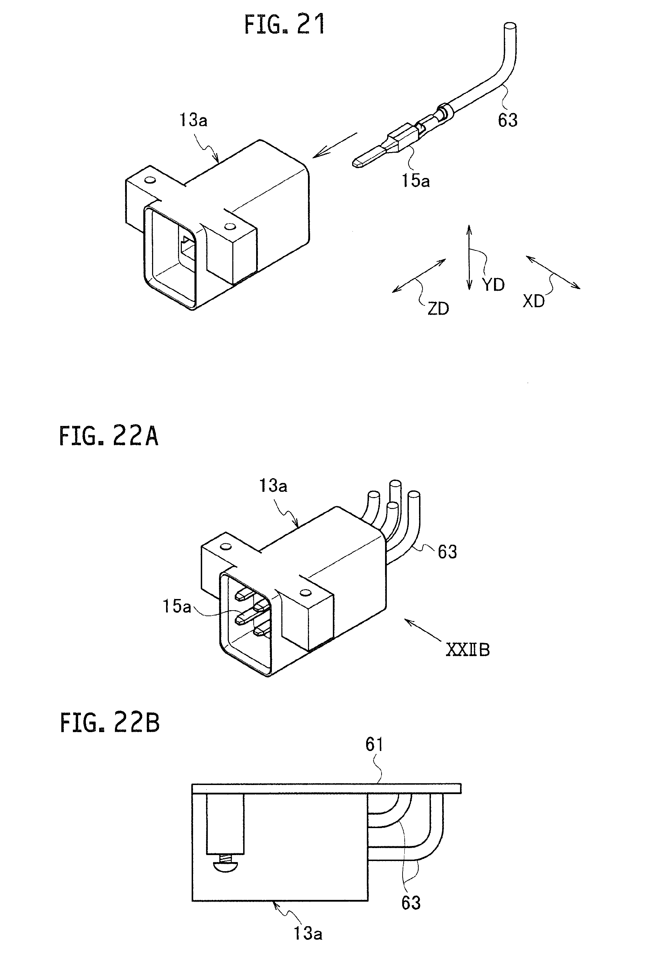

The second embodiment of the present invention is described in details by reference to FIGS. 19 to 26. A connector joining structure 2a according to the second embodiment includes: a casing 9a having the substantially same constitution as the casing 9 of the connector joining structure 2 according to the first embodiment; a mating connector 13a having the substantially same constitution as the first embodiment; a board 61; and a connector 1a.

The board 61 is integrally mounted on (fixed to) the casing 9a in the inside of the casing 9a. Although the mating connector 13a is mounted in the inside of the casing 9a, the mating connector 13a is connected to the board 61 through a flexible wire 63. Due to such a constitution, the mating connector 13a is not fixed to the casing 9a so that the mating connector 13a can freely change a position or a posture thereof to some extent within a range where the wire 63 is deformed with respect to the casing 9a.

A connector 1a is integrally mounted on the casing 9a thus being joined to the mating connector 13a.

The connector 1a is mounted on the casing 9a in a state where the connector 1a is positioned uniformly with respect to the casing 9a. That is, even when the mounting and the removal of the connector 1a are repeatedly performed, the positional displacement of the connector 1a mounted on the casing 9a with respect to the casing 9a does not occur, and the position of the connector 1a with respect to the casing 9a is always fixed.

An annular packing 21a having the substantially same constitution as the above-mentioned outer packing 21 is mounted on the connector joining structure 2a. The packing 21a is interposed between the casing 9a and the connector 1a for providing sealing between the casing 9a and the connector 1a.

Here, the connector joining structure 2a is described in further details.

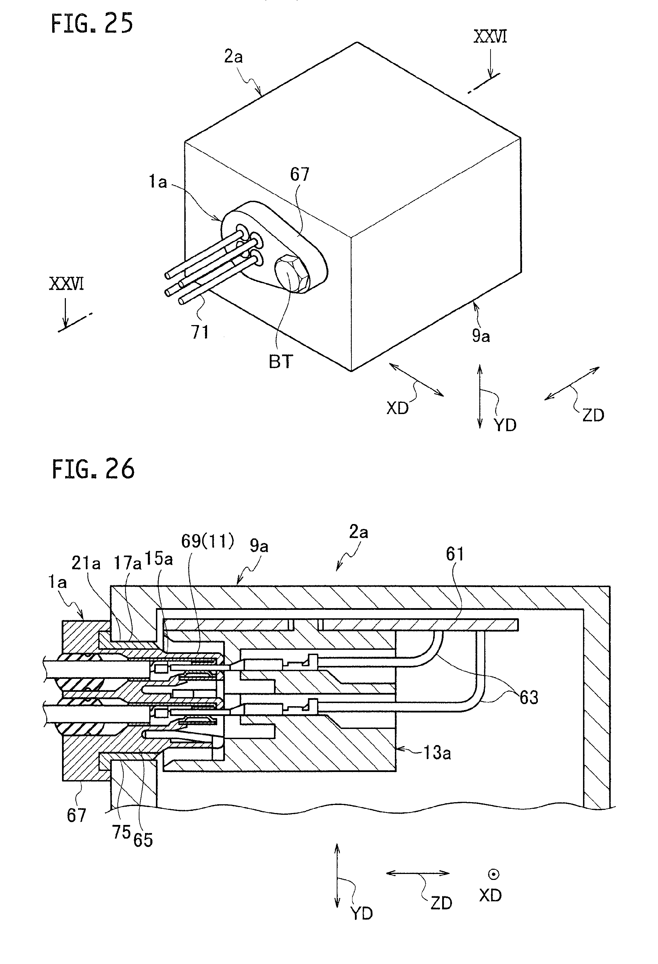

The connector 1a is not divided into an outer housing and an inner housing, and is formed of an integral body as shown in FIG. 20 and the like. The connector 1a includes: a body portion 65 formed into a rectangular parallelepiped shape; and a flange portion 67, for example. The extending direction of the center axis of the body portion 65 having a rectangular parallelepiped shape and the Z direction agree with each other. Cavities for mounting female terminals 69 mounted on end portions of electric wires 71 therein are formed on the body portion 65 (see FIG. 26).

By mounting the female terminals 69 mounted on the end portions of the electric wires 71 in the cavities, the electric wires 71 extend from the connector 1a.

The flange portion 67 is formed into a flat plate shape having a predetermined thickness, and projects from one side of an outer periphery of the body portion 65 in the substantially X direction on one end portion side of the body portion 65 in the Z axis direction. The thickness direction of the flange portion 67 projecting from the outer periphery of the body portion 65 is the Z direction. A through hole 73 which penetrates the flange portion 67 in the thickness direction is formed in the flange portion 67. The through hole 73 is used at the time of mounting the connector 1a on the casing 9a using a fastening tool such as a bolt BT (see FIG. 25).

The body portion 65 of the connector 1a projects from the other end of the flange portion 67 in the Z axis direction. An annular cut-away portion (or a groove) 75 for mounting the rectangular annular packing 21a therein is formed on the outer periphery of the projecting body portion 65. By inserting the packing 21a into the annular cut-away portion 75, the packing 21a is mounted on the connector 1a. In a state where the packing 21a is mounted on the connector 1a, an outer diameter of the packing 21a is set slightly larger than an outer diameter of the body portion 65.

In a state where the female terminals 69 are connected to the connector 1a, the electric wires 71 extend in the Z direction from an end of the body portion 65 on an end side of the body portion 65 where the flange portion 67 is formed. An outer shape and an inner shape of the casing 9a are formed into a rectangular parallelepiped shape, for example. A through hole 17a is formed in one wall portion 41a having a flat plate shape which constitutes the casing 9a, and the through hole 17a penetrates the wall portion 41a in the thickness direction (Z direction).

An inner diameter of the through hole 17a is substantially equal to the outer diameter of the body portion 65 of the connector 1a. In a state where the connector 1a is mounted on the casing 9a, the body portion 65 of the connector 1a is fitted into the through hole 17a, and the flange portion 67 of the connector 1a is brought into contact with the wall portion 41 outside the casing 9 so that the connector 1a is uniformly positioned with respect to the casing 9a in the X direction, the Y direction and the Z direction.

In a state where the connector 1a is mounted on the casing 9a, the packing 21a collapses due to elastic deformation thereof so that a sealing property between the casing 9a and the connector 1a is ensured.

Male terminals 15a are mounted on the mating connector 13a, and the wires (electric wires) 63 extend from one ends of the male terminals 15a. The male terminals 15a are integrally mounted on the mating connector 13a in a state where the male terminals 15a are inserted into the cavities formed in the mating connector 13a. The male terminals 15a are surrounded by a cylindrical hood portion 43a integrally formed with the mating connector 13a. An inner diameter of the hood portion 43a is substantially equal to an outer diameter of the body portion 65 of the connector 1a.

The board 61 is integrally mounted on the casing 9a in the inside of the casing 9a by a fastening tool such as bolts (not shown in the drawing). End portions of the electric wires 63 (end portion of the electric wires 63 on a side opposite to the male terminal 15a) are connected to a predetermined portion of the board 61. Due to such a constitution, the mating connector 13a is movable with respect to the casing 9a and the board 61 within a predetermined range allowed by the electric wires 71. The wires 63 may be directly connected to the board 61 by soldering or the like, or may be connected to the board 61 using a connector or the like provided separately.

In a state where the connector 1a is mounted on the casing 9a and is joined to the mating connector 13a and the terminals 69 on the connector 1a are connected to the terminals 15a of the mating connector 13a, the body portion 65 of the connector 1a (a portion of the body portion 65 on a side opposite to a side of the body portion 65 from which the electric wires 71 extend) is fitted into the hood portion 43a of the mating connector 13a. That is, an opening position of the mating connector 13a is positioned by making the opening position aligned with the connector 1a thus positioning the mating connector 13a with respect to the connector 1a.

Next, the mounting operation of the connector 1a is described.

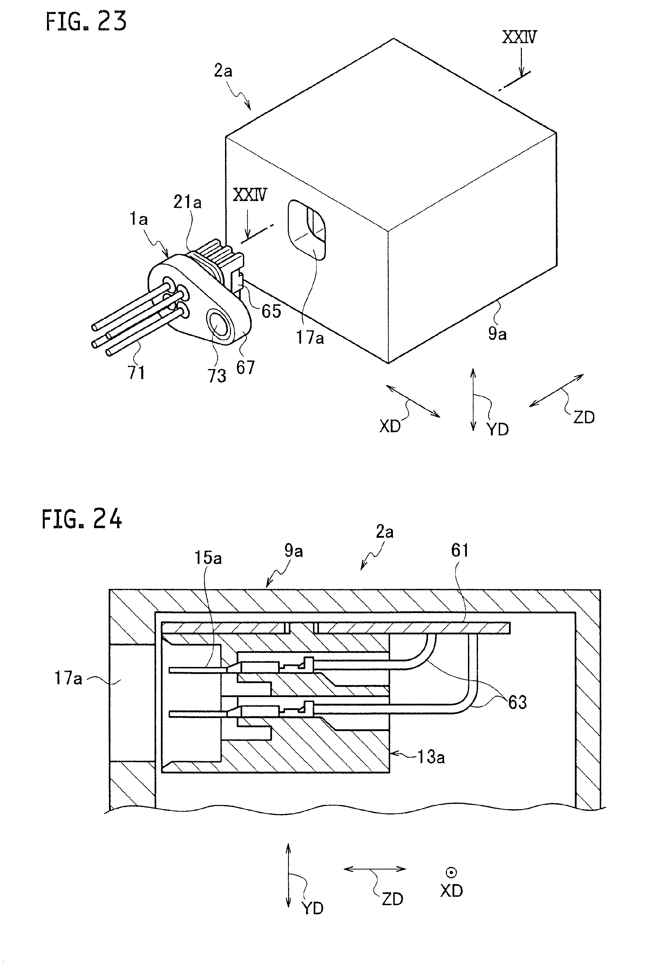

As shown in FIG. 23, FIG. 24 and the like, the mating connector 13a and the board 61 are mounted in the inside of the casing 9a in an initial state.

In the above-mentioned initial state, the body portion 65 projecting from the flange portion 67 of the connector 1a is inserted into the through hole 17a formed in the casing 9a and the female terminals 69 of the connector 1a are connected to the male terminals 15a of the mating connector 13a (see FIG. 26 or the like). In connecting the female terminals 69 of the connector 1a to the male terminals 15a of the mating connector 13a, the body portion 65 of the connector 1a is inserted into the hood portion 43a of the mating connector 13a so that the mating connector 13a is positioned with respect to the connector 1a, and the mating connector 13a is slightly moved with respect to the casing 9a (connector la). Subsequently, the connector 1a is fixed to the casing 9a by the bolt BT (see FIG. 25 or the like).

According to the connector joining structure 2a, the mating connector 13a is connected to the board 61 via the flexible wire 63. Due to such a constitution, at the time of joining the connector 1a to the mating connector 13a, the mating connector 13a can be freely moved with respect to the connector 1a to some extent and, at the same time, the mating connector 13a can change a posture thereof. Accordingly, the relative positioning between the mating connector 13a and the connector 1a can be easily performed.

Further, according to the connector joining structure 2a, the connector 1a is mounted on the casing 9a in a state where the connector 1a is uniformly positioned with respect to the casing 9a, and the packing 21a is interposed between the casing 9a and the connector 1a for providing sealing between the casing 9a and the connector 1a. Accordingly, there is no positional displacement of the connector 1a with respect to the casing 9a in the X direction and in the Y direction so that it is possible to surely provide sealing between the connector a and the casing 9a.

### Third embodiment

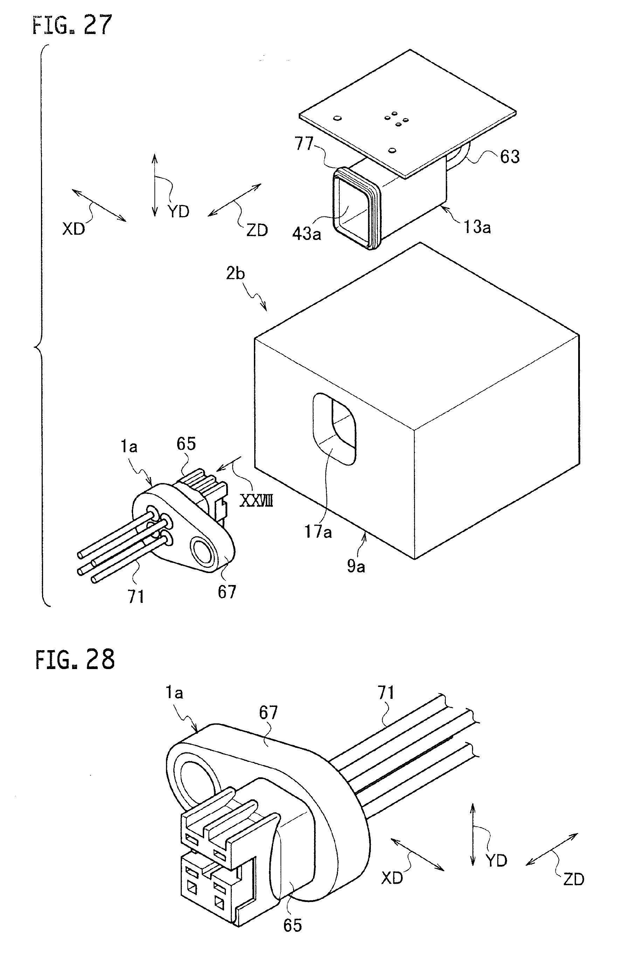

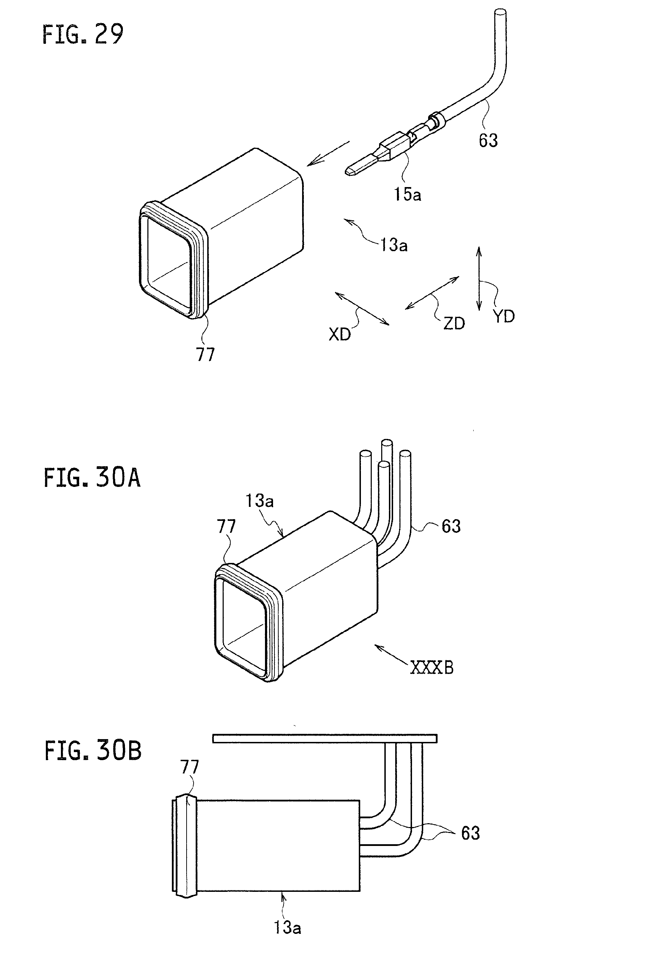

The third embodiment of the present invention is described in detail by reference to FIG. 27 to 34. As shown in FIG. 27 and the like, a connector joining structure 2b according to the third embodiment differs from the connector joining structure 2a according to the second embodiment with respect to a point that a packing 77 is mounted on a mating connector 13a, and other constitutions of the connector joining structure 2b according to the third embodiment are substantially equal to the corresponding constitutions of the connector joining structure 2a according to the second embodiment. Accordingly, the connector joining structure 2b according to the third embodiment can acquire the substantially same advantageous effect as the connector joining structure 2a according to the second embodiment.

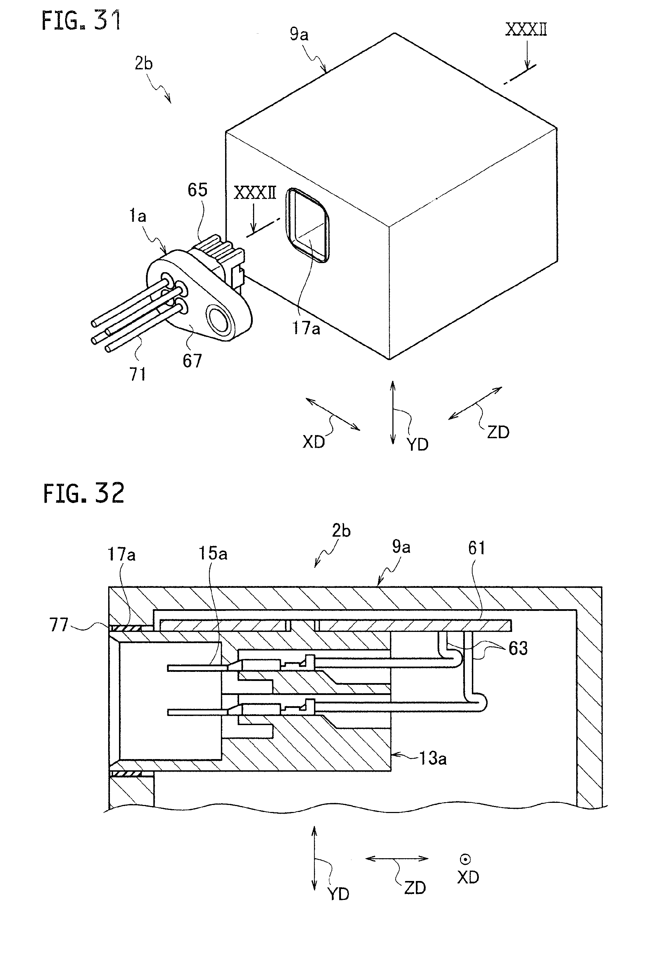

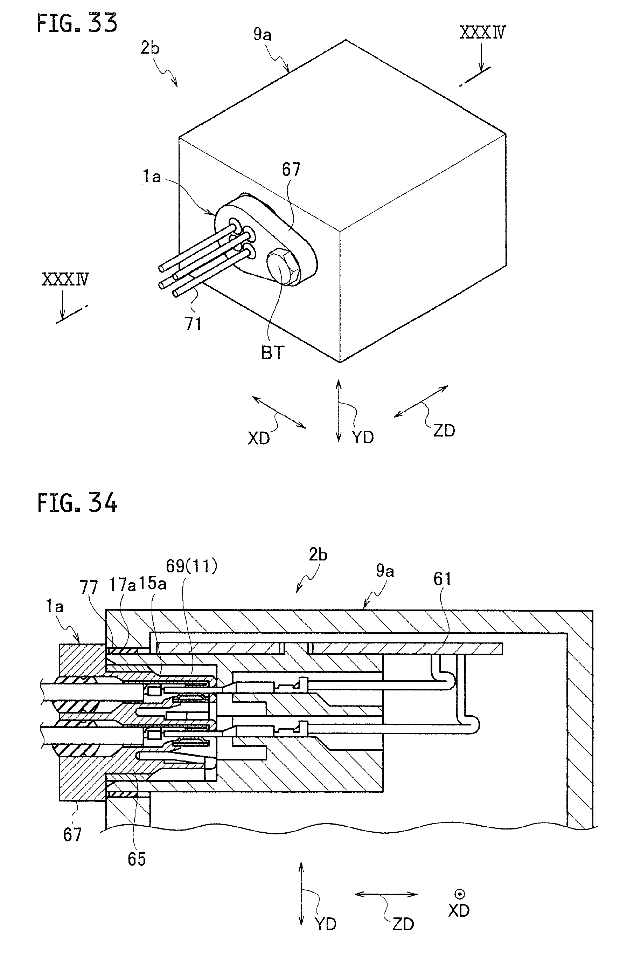

That is, in the connector joining structure 2b according to the third embodiment, the rectangular annular packing 77 is mounted on an outer periphery of an opening portion at a distal end of a hood portion 43a of the mating connector 13a. An outer diameter of the packing 77 is slightly larger than an outer diameter of the hood portion 43a and an inner diameter of a through hole 17a formed in a casing 9a, and an outer diameter of the hood portion 43a is slightly smaller than the inner diameter of the through hole 17a formed in the casing 9a. When the mating connector 13a on which the packing 77 is mounted is mounted in the casing 9a, the packing 77 and the hood portion 43a are inserted into the through hole 17a formed in the casing 9a so that sealing is provided between the casing 9a and the mating connector 13a (see FIG. 32 and FIG. 34). Here, the mating connector 13a may be movable with respect to the casing 9a in the X direction and in the Y direction within a range of elastic deformation of the packing 77.

In a state where the mating connector 13a is mounted in the casing 9a, the connector 1a is mounted on the casing 9a and is joined to the mating connector 13a. Here, sealing may be provided also between the connector 1a and the casing 9a by the packing (not shown in the drawing). Further, the packing 77 may also have a function of providing sealing between the connector 1a and the casing 9a.

### Fourth embodiment

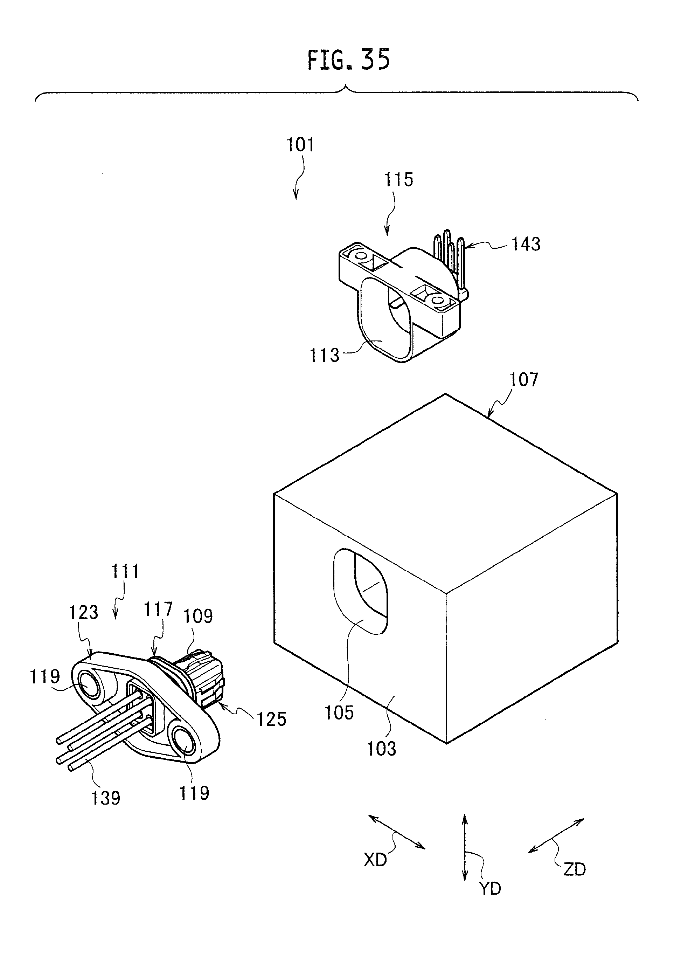

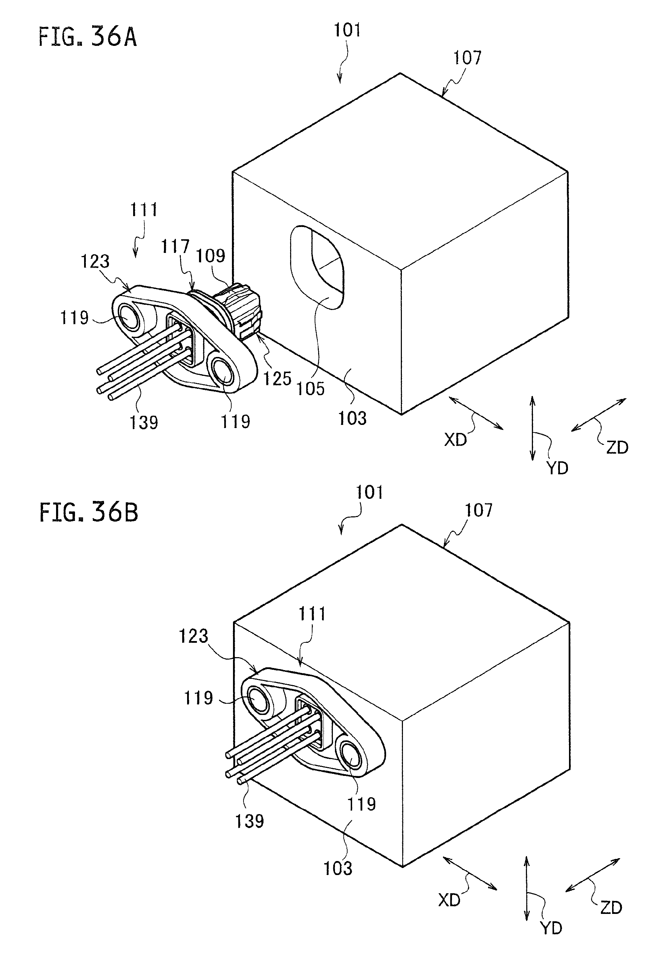

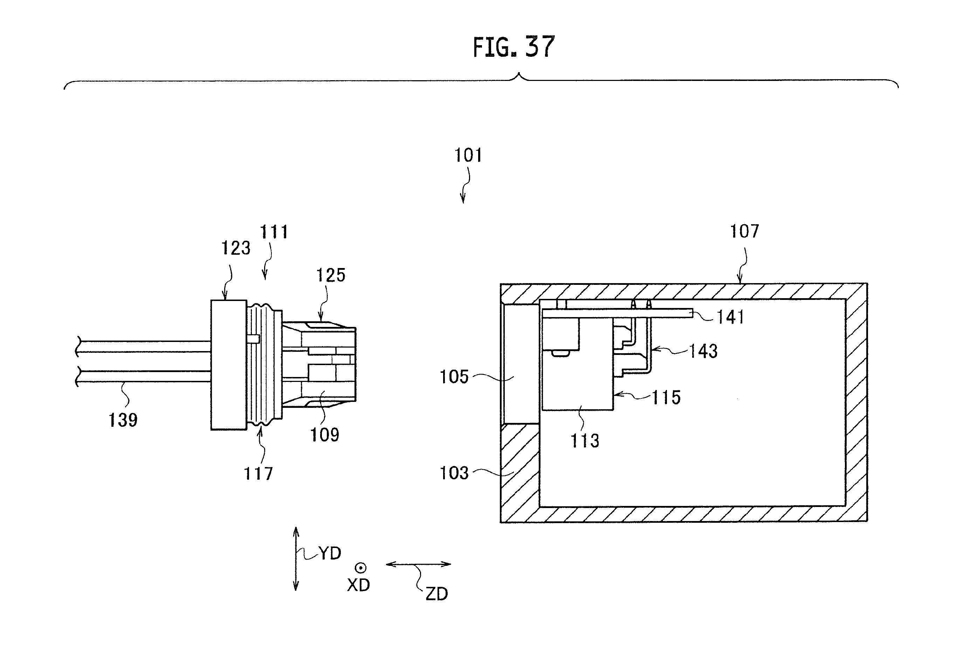

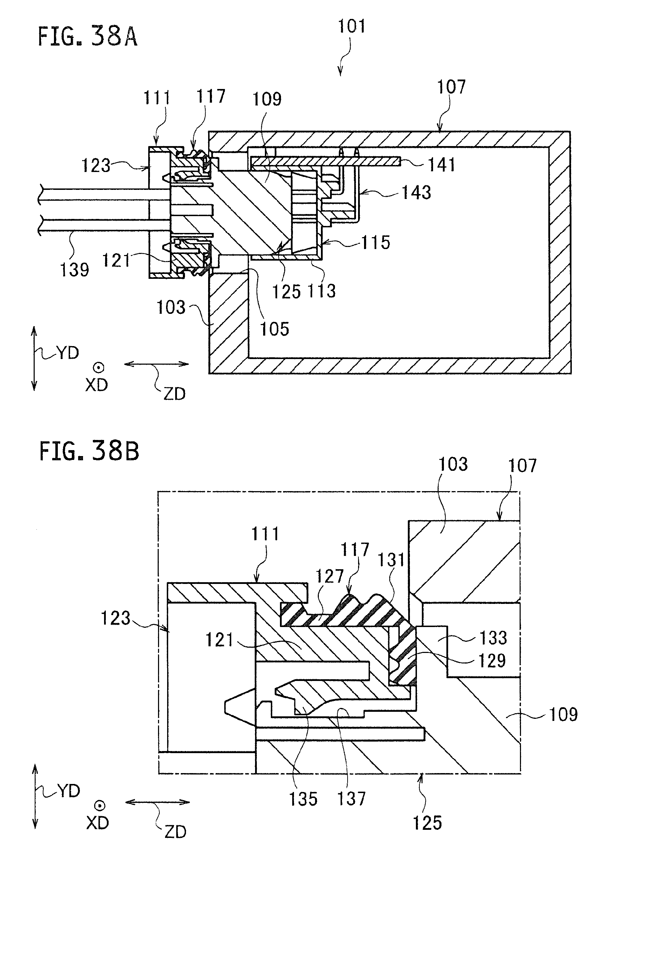

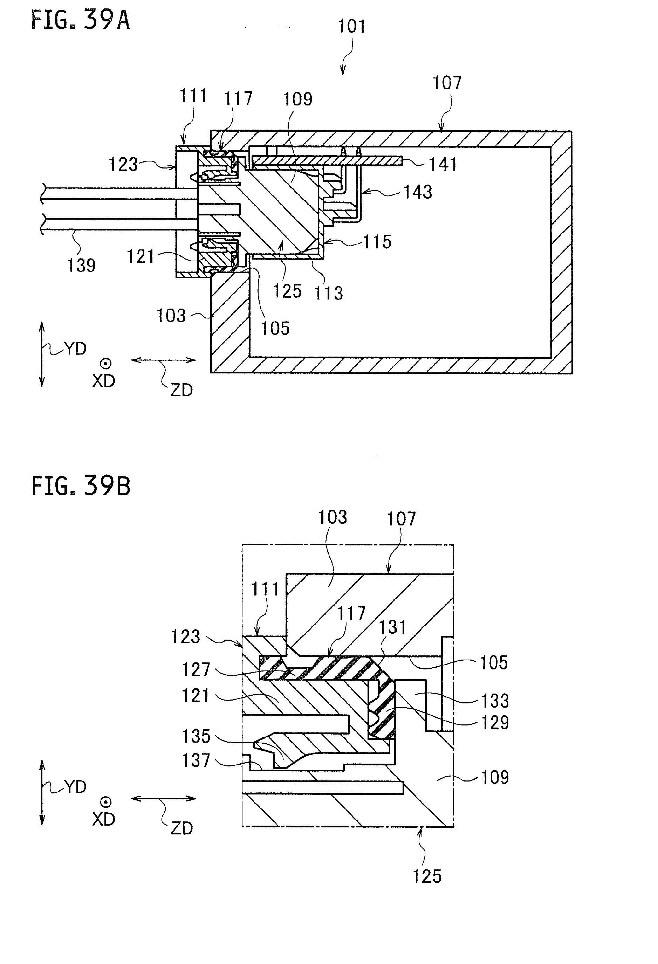

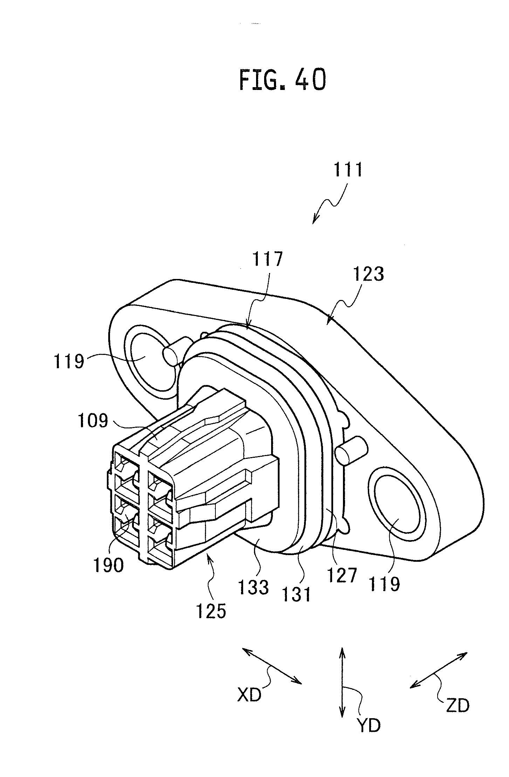

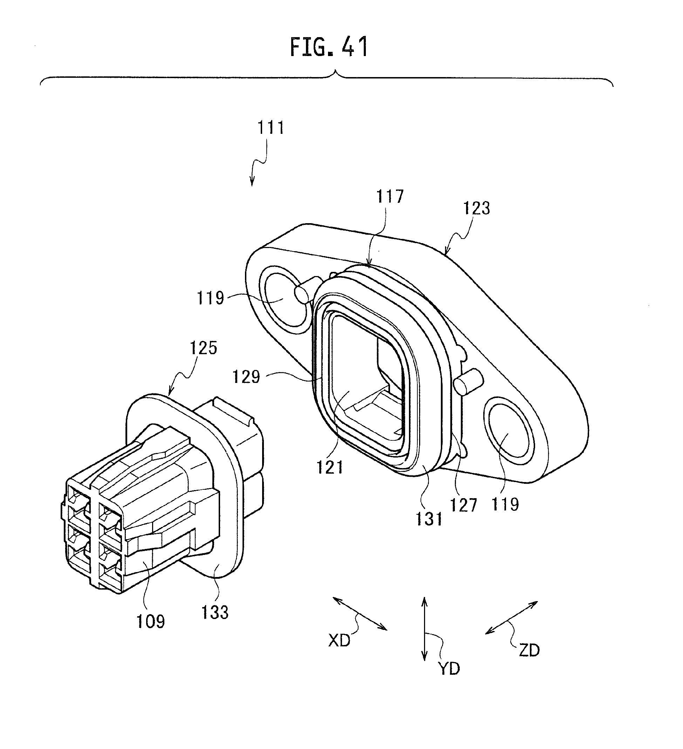

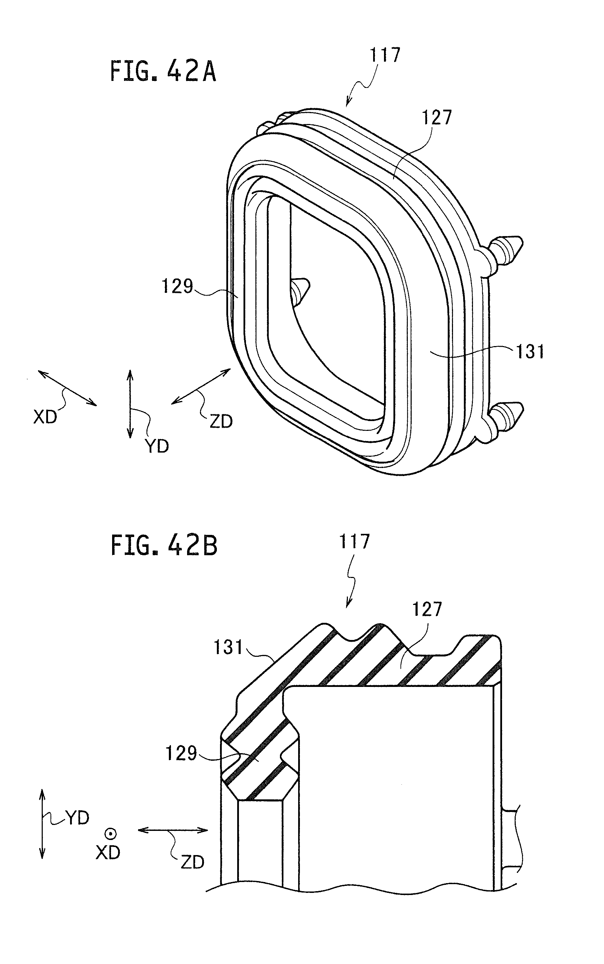

A connector joining structure 101 according to the fourth embodiment of the present invention is described in details by reference to FIGS. 35 to 43B. The connector joining structure 101 according to the fourth embodiment differs from the connector joining structure according to the first embodiment with respect to a point that an inner packing 129 and an outer packing 127 are formed of a single integrally continuous member.

The connector joining structure 101 includes: a connector 111 having a body portion 109 inserted into a through hole 105 formed in a side wall 103 constituting a wall portion; and a sealing member 117 mounted on an outer periphery of the connector 111 in a close contact manner and brought into close contact with the through hole 105 so as to partition one side and the other side of the side wall 103.

The connector 111 includes: an outer housing 123 in which through holes 119 formed in fixing portions of the outer housing 123 fixed to the side wall 103 and an accommodating hole 121 which extends toward the through hole 105, is inserted into the inside of the through hole 105, and is communicated with the through hole 105 are formed; and an inner housing 125 which has a body portion 109 which is inserted into the accommodating hole 121 formed in the outer housing 123.

The sealing member 117 is formed of a single member where the outer packing 127 which is brought into close contact with the accommodating hole 121 and the through hole 105 thus partitioning one side and the other side of the side wall 103, and the inner packing 129 which is brought into close contact with a surface of the outer housing 123 and a surface of the inner housing 125 which face each other in an opposed manner thus partitioning the outer housing 123 and the inner housing 125 are formed as a single continuous member.

The sealing member 117 is formed by connecting the outer packing 127 and the inner packing 129 to each other, and a tapered surface is formed on an opposedly-facing portion 131 of the sealing member 117 which faces an edge portion of the through hole 105 in an opposed manner.

On a side of the side wall 103 opposite to a side where the connector 111 is arranged, a mating connector 115 having a hood portion 113 which can be fitted on the body portion 109 inserted through the through hole 105 is arranged.

As shown in FIG. 35 to FIG. 42B, the side wall 103 which constitutes the wall portion forms a side wall of a casing 107 on which the connector 111 is mounted. Accordingly, one side and the other side of the side wall 103 constitute an outer side and an inner side of the casing 107 respectively. Equipment (not shown in the drawing) and the like are accommodated in the inside of the casing 107.

The through hole 105 is formed in the side wall 3 of the casing 107 in a penetrating manner such that the outside and the inside of the casing 107 communicate with each other. The body portion 109 of the connector 111 is inserted into the through hole 105 in the direction toward the inside of the casing 107 from the outside.

The connector 111 is formed of the outer housing 123 and the inner housing 125. The outer housing 123 is made of an insulating material such as a synthetic resin, is formed into a rhombic shape, and has the through holes 119 and the accommodating hole 121.

The through hole 119 is formed on both sides of the outer housing 123 respectively, and forms a bolt insertion hole through which a bolt is inserted. In a state where the body portion 109 of the connector 111 and the hood portion 113 of the mating connector 115 are engaged with each other by fitting engagement, the bolts are inserted into the through holes 119 and are fastened to the side wall 103 of the casing 107 so that the outer housing 123 is fixed to the side wall 103.

In this manner, by fixing the connector 111 to the casing 107 by making use of the through holes 119, even when an external force such as a tensile force is applied to electric wires 139, it is possible to absorb the external force by the through holes 119. Accordingly, it is possible to suppress an effect of an external force exerted on the fitting engagement between the body portion 109 of the connector 111 and the hood portion 113 of the mating connector 115.

The accommodating hole 121 is formed at a center portion of the outer housing 123 in a penetrating manner. The accommodating hole 121 is formed of a single member which is continuously formed with the outer housing 123 and extends toward a through hole 105 side of the casing 107 from an opening end.

In a state where the outer housing 123 is mounted on the casing 107, an extending portion of the accommodating hole 121 is arranged in the inside of the through hole 105 of the casing 107 so that the accommodating hole 121 is communicated with the through hole 105. The inner housing 125 is accommodated in the inside of the accommodating hole 121.

The inner housing 125 is made of an insulating material such as a synthetic resin, and is formed into a box shape. The inner housing 125 is accommodated in the inside of the accommodating hole 121 formed in the outer housing 123, and includes the body portion 109 and a flange portion 133.

Engaging arms 135 are formed on an inner surface of the accommodating hole 121 of the outer housing 123 in a deflectable manner, and engaging grooves 137 with which the engaging arms 135 are engageable are formed on the inner housing 125 along the engaging direction. Due to such a constitution, it is possible to prevent the removal of the inner housing 125 in a state where the inner housing 125 is assembled to the outer housing 123.

The body portion 109 is formed into a box shape so as to be insertable into the through hole 105 of the casing 107. By accommodating a portion of the connector 111 positioned on an outer housing 123 side from the body portion 109 in the inside of the accommodating hole 121, the body portion 109 is positioned in front of an extending portion of the accommodating hole 121 in the fitting engaging direction.

The body portion 109 is inserted into the through hole 105 of the casing 107 at the time of making the connector 111 and the mating connector 115 engage with each other by fitting engagement. First terminals 190 each of which is formed of a female terminal having a box-shaped connecting portion in the inside thereof are accommodated in the body portion 109.

The first terminals 190 are made of an electrically conductive material, are electrically connected to terminal portions of a plurality of electric wires 139 connected to equipment, a power source (not shown in the drawing) or the like, and are accommodated in the inside of the body portion 109. A sealing member (not shown in the drawing) is mounted on the electric wire 139 to which the first terminal 190 is connected. The sealing members are brought into close contact with outer peripheries of the electric wires 139 and inner peripheral surfaces of the body portion 109 and partition the inside and the outside of the body portion 109 from each other.

The flange portion 133 is formed of a single member which is continuously formed on an outer periphery of the inner housing 125 in the circumferential direction and outwardly extending manner. An outer diameter of the flange portion 133 is set larger than an outer diameter of the body portion 109 and is set to allow the insertion of the flange portion 133 into the through hole 105 of the casing 107. The flange portion 133 is arranged so as to face an end surface of the accommodating hole 121 of the outer housing 123 in the fitting engagement direction in a state where the inner housing 125 is assembled to the outer housing 123.

When the body portion 109 is inserted into the through hole 105 of the casing 107 and the body portion 109 is fitted in the hood portion 113 of the mating connector 115, connecting portions of second terminals 143 accommodated in the inside of the hood portion 113 are inserted into the first terminals 190 which are accommodated in the body portion 109 of the connector 111 whereby the first terminals 190 and the second terminals 143 are electrically connected to each other.

The mating connector 115 is made of an insulating material such as a synthetic resin, and is formed into a box shape. The hood portion 113 which has one end side thereof opened and into which the body portion 109 of the connector 111 is fitted is formed on the mating connector 115.

The mating connector 115 is mounted on a surface of a printed circuit board 141 on which electronic parts (not shown in the drawing) and the like are mounted, and is fixed to the board 141 by means of fixing members (not shown in the drawing) such as screws. The connecting portions of the second terminals 143 are arranged in the inside of the hood portion 113 of the mating connector 115.

The second terminals 143 are made of an electrically conductive material, and are formed into an L shape. The second terminal 143 has the connecting portion which is formed into a tub shape and is arranged in the inside of the hood portion 113 on one end side thereof, and a board connecting portion which is electrically connected to a conductor portion of the board 141 by soldering or the like on the other end side thereof.

The mating connector 115 which accommodates the second terminals 143 therein is accommodated in the inside of the casing 107 in a state where the mating connector 115 is assembled to the board 141. In such an accommodating state, an opening of the hood portion 113 of the mating connector 115 is positioned in the through hole 105 of the casing 107. By inserting the body portion 109 of the connector 111 through the through hole 105, the body portion 109 and the hood portion 113 are engaged with each other by fitting engagement so that the first terminals 190 and the second terminals 143 are electrically connected with each other.

In the connector joining structure 101, between the casing 107 and the connector 111 as well as between the outer housing 123 and the inner housing 125, the sealing member 117 is interposed so as to partition the outside and the inside of the casing 107 and, at the same time, to partition the outer housing 123 and the inner housing 125, that is, the inside and the outside of the inner housing 125. With the use of the sealing member 117, it is possible to prevent the intrusion of water or the like into the inside of the casing 107 or into the inside of the inner housing 125 from the outside.

The sealing member 117 is made of an elastic material such as rubber, and is formed into an annular shape. The sealing member 117 has the outer packing 127 and the inner packing 129.

The outer packing 127 is mounted on an outer periphery of an extending portion of the accommodating hole 121 formed in the outer housing 123 of the connector 111 in a close contact manner. An outer diameter of the outer packing 127 is set larger than an inner diameter of the through hole 105 formed in the casing 107.

By inserting the extending portion of the accommodating hole 121 formed in the outer housing 123 in the through hole 105 of the casing 107, the outer packing 127 is arranged such that an outer peripheral surface of the outer packing 127 is brought into close contact with an inner peripheral surface of the through hole 105. Due to such assembling of the outer packing 127 into the through hole 105, the inside and the outside of the casing 107 are partitioned from each other so that a sealing property between the casing 107 and the connector 111 is ensured. The inner packing 129 is formed on the outer packing 127 using a single continuous member.

The inner packing 129 is formed of a single member which continuously extends from the outer packing 127 toward an end surface of the extending portion of the accommodating hole 121 in the fitting engagement direction. By forming the inner packing 129 in this manner, the outer packing 127 is positioned at an end surface of the accommodating hole 121 in the fitting engagement direction in a state where the outer packing 127 is mounted on an outer peripheral surface of the accommodating hole 121 formed in the outer housing 123 in a close contact manner.

In a state where the outer housing 123 and the inner housing 125 are assembled to each other, the inner packing 129 is disposed between a surface of the accommodating hole 121 formed in the outer housing 123 and a surface of the flange portion 133 of the inner housing 125 which face each other in an opposed manner in the insertion direction of the body portion 109 with respect to the accommodating hole 121.

In engaging the body portion 109 of the connector 111 and the hood portion 113 of the mating connector 115 by fitting engagement, a surface of the body portion 109 and a surface of the hood portion 113 which face each other in an opposed manner in the fitting engagement direction are brought into contact with each other so that the movement of the inner housing 125 in the fitting engagement direction is restricted. Accordingly, the inner packing 129 disposed as described above collapses toward an accommodating hole 121 side by the flange portion 133 so that the inner packing 129 is brought into close contact with the end surface of the accommodating hole 121 and the flange portion 133.

Due to such close contact of the inner packing 129 with the end surface of the accommodating hole 121 and the flange portion 133, the inside and the outside of the inner housing 125 are partitioned from each other and hence, a sealing property between the outer housing 123 and the inner housing 125 is ensured.

The sealing member 117 is formed by connecting the outer packing 127 and the inner packing 129 to each other, and a tapered surface is formed on the opposedly-facing portion 131 of the sealing member 117 which faces an edge portion of the through hole 105 in an opposed manner. The opposedly-facing portion 131 alleviates an impact generated by a contact of the sealing member 117 with the edge portion of the through hole 105 by the tapered surface at the time of inserting the sealing member 117 into the through hole 105 of the casing 107.

By alleviating an impact generated by a contact between the sealing member 117 and the edge portion of the through hole 105 by the opposedly-facing portion 131 on which the tapered surface is formed, peeling off of a sealing surface from an outer peripheral surface of the accommodating hole 121 formed in the outer packing 127 or peeling off of a sealing surface from a portion between the end surface of the accommodating hole 121 formed in the inner packing 129 and the flange portion 133 can be prevented.

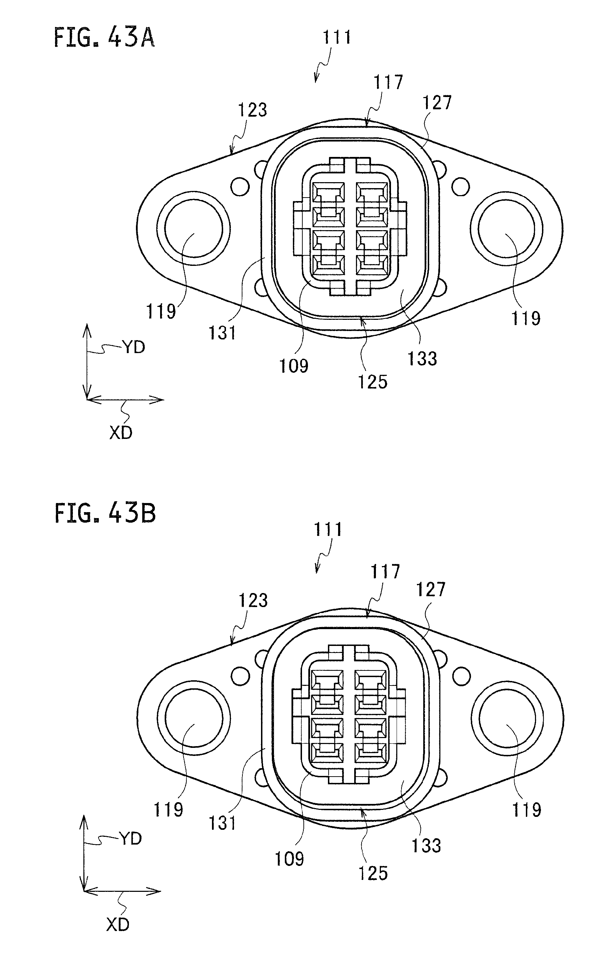

On the other hand, the outer packing 127 of the sealing member 117 has a function of aligning the body portion 109 and the hood portion 113 in the direction orthogonal to the fitting engagement direction of the connector 111 and the mating connector 115 (the plane direction formed by the X direction and the Y direction in FIG. 43A).

For example, when an opening of the hood portion 113 of the mating connector 115 is positionally displaced with respect to the through hole 105 of the casing 107 in the direction orthogonal to the fitting engagement direction, as shown in FIG. 43B, the positional displacement in such a direction can be absorbed by changing a collapse amount of the outer packing 127 of the sealing member 117.

In the connector joining structure 101, the sealing member 117 is formed of a single member where the outer packing 127 which partitions the inside and the outside of the casing 107 and the inner packing 129 which partitions the outer housing 123 and the inner housing 125 are continuously formed. Due to the above-mentioned constitution, it is unnecessary to perform the partitioning of the inside and the outside of the casing 107 and the partitioning of the outer housing 123 and the inner housing 125 using different sealing members respectively and hence, the number of parts can be reduced.

Accordingly, in the connector joining structure 101, the partitioning of the inside and the outside of the casing 107 and the partitioning of the outer housing 123 and the inner housing 125 can be performed using one sealing member 117. Due to such a constitution, the number of parts of the sealing member can be reduced thus lowering a manufacturing cost.

The sealing member 117 is formed by connecting the outer packing 127 and the inner packing 129 to each other, and the tapered surface is formed on the opposedly-facing portion 131 of the sealing member 117 which faces an edge portion of the through hole 105 in an opposed manner. Accordingly, it is possible to alleviate an impact generated by a contact between the edge portion of the through hole 105 and the opposedly-facing portion 131 of the sealing member 117 so that peeling off of a sealing surface of the sealing member 117 can be prevented thus ensuring a sealing property.

On a side of the side wall 103 opposite to a side of the side wall 103 where the connector 111 is arranged, the mating connector 115 having the hood portion 113 which is engageable with the body portion 109 inserted through the through hole 105 by fitting engagement is arranged. Accordingly, it is possible to prevent the intrusion of water or the like into a mating connector 115 side from a connector 111 side by the sealing member 117.

Further, in the same manner as the first embodiment, the connector 111 is divided into the outer housing 123 and the inner housing 125, and even when the position of the inner housing 125 with respect to the outer housing 123 is displaced in a three-dimensional space by a predetermined amount with respect to a target value, it is possible to ensure a sealing property between the outer housing 123 and the inner housing 125 by the inner packing 129. Accordingly, even when the position of the inner housing 125 is displaced at the time of engaging the connector 1111 (inner housing 125) with the mating connector 115 mounted in the casing 107 by fitting engagement, it is possible to eliminate a gap formed in the connector 111 thus acquiring waterproof property and guarantee of fitting engagement including guarantee of connection between the first terminals 190 and the second terminals 143.

In the connector joining structure 101 according to the fourth embodiment, the inner packing 129 of the sealing member 117 is interposed between the end surface of the accommodating hole 121 and the flange portion 133. However, the arrangement of the inner packing 129 of the sealing member 117 is not limited to such an arrangement. For example, the inner packing 129 may extend to an inner peripheral surface of the accommodating hole 121 thus bringing the inner packing 129 into close contact with the inner peripheral surface of the accommodating hole 121 and the outer peripheral surface of the body portion 109.

Further, the connector 111 is fixed to the side wall 103 of the casing 107 by means of the bolts through the through holes 119. However, the fixing of the connector 111 is not limited to the above. For example, a fixing portion of the connector 111 may be fixed to the side wall 103 of the casing 107 by means of an adhesion means or an engaging means.

Embodiments of the present invention have been described above. However, the invention may be embodied in other specific forms without departing from the spirit or essential characteristics thereof. The present embodiments are therefore to be considered in all respects as illustrative and not restrictive, the scope of the invention being indicated by the appended claims rather than by the foregoing description and all changes which come within the meaning and range of equivalency of the claims are therefore intended to be embraced therein.

Moreover, the effects described in the embodiments of the present invention are only a list of optimum effects achieved by the present invention. Hence, the effects of the present invention are not limited to those described in the embodiment of the present invention.

Further, the features of all embodiments and all claims can be combined with each other as long as they do not contradict each other.

## Claims

1. A connector joining structure comprising:
an outer housing mounted on a casing;
an inner housing having a terminal to be connected to a terminal of a mating connector mounted in the casing; and
a first packing interposed between the outer housing and the inner housing and configured to ensure sealing property between the outer housing and the inner housing even upon a position of the inner housing with respect to the outer housing being displaced in at least one of three directions in a three-dimensional space by a predetermined amount with respect to a target value.

2. The connector joining structure according to claim 1, wherein the first packing is configured to ensure the sealing property by elastic deformation.

3. The connector joining structure according to claim 1, further comprising:
the casing having a first through hole;
the mating connector mounted in the casing; and
a second packing interposed between the casing and the outer housing, wherein
the outer housing
has a second through hole, and
is mounted on the casing outside the casing with the second through hole positioned inside the first through hole, and
the inner housing is mounted in the outer housing with a portion of the inner housing inserted into the second through hole.

4. The connector joining structure according to claim 1, further comprising a bolt for fixing the outer housing to the casing,
wherein a gap is formed between the outer housing and the casing with the bolt insufficiently fastened.

5. The connector joining structure according to claim 1, wherein
the first packing has a lip portion, and
the lip portion has an asymmetrical shape with respect to a center line of the lip portion and configured to always collapse toward one side upon a change of the position of the inner housing due to a connection of the terminal of the inner housing to the terminal of the mating connector.

6. The connector joining structure according to claim 5, wherein a gradient of an annular inclined surface inside a vertex of the lip portion and a gradient of an annular inclined surface outside the vertex are different from each other.

7. The connector joining structure according to claim 1, further comprising a connector having the inner housing and the outer housing, wherein
the inner housing comprises a body portion to be inserted into a through hole formed in a wall portion of the casing,
the outer housing comprises
a fixing portion to be fixed to the wall portion, and
an accommodating hole extending toward the through hole and communicated with the through hole with the accommodating hole inserted into an inside of the through hole,
the body portion is insertable into the accommodating hole,
the first packing is configured to partition the outer housing and the inner housing with the first packing in close contact with surfaces of the outer housing and the inner housing facing each other, and
the connector joining structure further comprises a second packing configured to partition one side and the other side of the wall portion with the second packing in close contact with the accommodating hole and the through hole, the second packing being formed of a single member continuous with the first packing.

8. The connector joining structure according to claim 7, wherein an opposedly-facing portion connecting the first packing and the second packing to each other and facing an edge portion of the through hole is formed in a tapered surface.

9. The connector joining structure according to claim 7, further comprising the mating connector,
wherein the mating connector
is arranged on a side of the wall portion opposite to a side of the wall portion where the connector is arranged, and
comprises a hood portion engageable with the body portion inserted through the through hole.

10. A connector joining structure comprising:
a casing;
a board mounted on the casing;
a wire being flexible and connected to the board;
a mating connector connected to the board via the wire, and
a connector to be joined to the mating connector with the connector mounted on the casing.

11. The connector joining structure according to claim 10, further comprising a packing interposed between the casing and the connector and configured to seal between the casing and the connector,
wherein the connector is mounted on the casing with the connector positioned with respect to the casing.

12. A packing for sealing between a first member and a second member integrally mounted on the first member, the packing comprising:
a lip portion,
wherein the lip portion has an asymmetrical shape with respect to a center line of the lip portion and configured to always collapse toward one side upon a change of a position of the second member with respect to the first member at a time of mounting the second member on the first member.
